# EUROPEAN PATENT APPLICATION

(11) **EP 4 539 116 A1**
(43) Date of publication of application: **16.04.2025**
(21) Application number: 24173985.3
(22) Date of filing: 03.05.2024
(51) Int. Cl.: H01L 23/373, C04B 37/02, H05K 1/02, H05K 1/03

(54) **A HEAT DISSIPATION SUBSTRATE FOR A POWER SEMICONDUCTOR MODULE, A POWER SEMICONDUCTOR MODULE INCLUDING THE HEAT DISSIPATION SUBSTRATE, AND A POWER CONVERTER INCLUDING THE POWER SEMICONDUCTOR MODULE**

(30) Priority: 10.10.2023 KR 20230134184
(71) Applicant: LX Semicon Co., Ltd., Daejeon 34027 (KR)
(72) Inventor: JANG, Min Yup, 34027 Daejeon (KR)
(74) Representative: Goddar, Heinz J.

(57) **Abstract**

The embodiment relates to a power converter including a power semiconductor module and a power semiconductor module, and a method of manufacturing the same comprising an insulating substrate for a heat dissipation substrate, a heat dissipation substrate for a power semiconductor module, a power semiconductor module including a heat dissipation substrate.

A heat dissipation substrate for a power semiconductor module according to an embodiment may include a first metal plate, an insulating substrate bonded to the first metal plate, and a second metal plate bonded to the insulating substrate. A first thickness of the first metal plate may be different from the second thickness of the second metal plate. The first thickness of the first metal plate may be thinner than the second thickness of the second metal plate. The first metal plate may comprise a circuit pattern electrically connected to a power semiconductor device, and the second metal plate may include a marked unique code.

## Description

### TECHNICAL FIELD

The embodiment relates to a ceramic substrate for a heat dissipation substrate, a heat dissipation substrate for a power semiconductor module, a power semiconductor module including the same, a power converter including the same, and a method of manufacturing the same.

### BACKGROUND

The power converter module is a device that performs power converter (AC->DC, DC->AC), power transformation (step-down, step-up), power distribution, or power control. And the power converter module is a key component that improves energy efficiency in the process of transmitting and controlling power and provides system stability and reliability by controlling voltage changes. And the power converter module is referred to as power modules or power systems.

The power converter module includes various components such as power semiconductor devices, heat dissipation substrates, base plates, molding silicon, cases and covers, and terminals.

Recently, eco-friendly vehicles based on electricity or hydrogen have been in the spotlight instead of fossil fuel-based internal combustion engine vehicles, and numerous power semiconductor devices are used in these eco-friendly vehicles. Eco-friendly vehicles include hybrid vehicles (HEV), plug-in hybrid vehicles (PHEV), electric vehicles (EV), and fuel cell vehicles (PCEV).

In addition, a power semiconductor is used in a variety of electrical and electronic devices, such as electric vehicle chargers, energy storage devices, power supply devices, and railroads, in addition to eco-friendly vehicles.

Previously, silicon (Si) power semiconductor devices have been widely used, but as Si power semiconductors have reached their physical limits, to replace this, research is being actively conducted on WBG (wide bandgap) power semiconductors such as silicon carbide (SiC) or gallium nitride (GaN).

WBG power semiconductor devices have a bandgap energy that is about 3 times higher than that of Si power semiconductor devices, a breakdown field that is about 10 times higher than that of Si power semiconductor devices, and thermal conductivity that is about 3 times higher than that of Si power semiconductor devices. Due to these excellent characteristics, the WBG power semiconductor device can operate in a high temperature and high voltage environment and has the advantage of high switching speed and low switching loss.

For example, Si-based power semiconductor modules used to perform power converter (DC↔AC), motor drive switching, and control in conventional electric vehicles, hybrid electric vehicles, etc. were operated in a temperature environment of around 150°C. In response to recent demands for increased switching performance and power density, research has been actively conducted on wide band gap (WBG)-based power semiconductor devices such as SiC or GaN that can operate at operating temperatures above approximately 300°C, for example, approximately 300~700°C.

Meanwhile, the heat generated from the power semiconductor generates thermomechanical stress in each part of the power semiconductor module, and the life of the bonding and the power semiconductor device may be deteriorated due to thermal fatigue of the bonding. Therefore, it is very important to design the reliability of the power semiconductor module to properly dissipate the heat generated from the power semiconductor device through the heat dissipation substrate to maintain the bonding temperature of the power semiconductor device below an appropriate temperature.

Meanwhile, the heat dissipation substrate for power semiconductors not only has the function of transferring heat generated during operation of power semiconductor devices to the outside, but also has an important function of electrically connecting power semiconductor devices by forming a wiring pattern on one side of the heat dissipation substrates.

Conventional heat dissipation substrates for power semiconductors can be classified into direct bonded copper (DBC) and active metal brazing (AMB) methods depending on the bonding method. The DBC method is a method of forming an oxide film on the copper (Cu) layer and then bonding it directly to the ceramic. The AMB method is a method of performing brazing by interposing a paste containing metal particles with a relatively low melting point between the base metal and ceramic as an intermediate material.

However, recently, 1200V, 200A level high-voltage/high-power SiC power converter modules are being used to improve the performance of hybrid and electric vehicles and autonomous vehicles. During operation of these high-performance electric vehicles, the operating temperature of power semiconductor devices is required to be above 300°C on average. In particular, it is facing ultra-high temperature usage conditions where the instantaneous maximum operating temperature is over 350°C.

In such an ultra-high temperature, high voltage, and high current operating environment, the existing bonding materials themselves may re-melt, and a heat trap phenomenon may occur due to pores present in the bonding area. As a result, the life of the power semiconductor module may rapidly deteriorate.

For example, cracks may occur due to defects caused at the interface between the ceramic substrate of the heat dissipation substrate and the copper (Cu) sheet. Cracks induced in such heat dissipation substrates can cause thermal runaway, leading to the destruction of power semiconductor devices.

For example, if heat dissipation performance deteriorates due to cracks in the heat dissipation substrate, the temperature of the power semiconductor module case and surroundings may increase. At this time, if the heat generation exceeds the heat dissipation performance due to a rapid temperature rise (heat state > heat dissipation performance), the thermal balance according to the thermal design (heat state < heat dissipation performance) is not maintained and the heat generation continues to increase. As a result, the leakage current continues to increase, ultimately leading to the destruction of the power semiconductor module itself.

In particular, deterioration problems of power semiconductor modules may occur in ultra-high operating temperature environments. Destruction of power semiconductor devices caused by malfunction of power semiconductor modules mounted on vehicles can have a serious impact on driver safety.

Meanwhile, in the current field of heat dissipation substrates, thickness of supplied substrates including ceramic substrates is not constant, and thickness of supplied metal plate, such as copper plates, is also not constant. In this situation, the final heat dissipation substrates must comply with the strict specifications for heat dissipation substrates delivery standards, but there are many difficulties in producing heat dissipation substrates that can meet the strict thickness specifications.

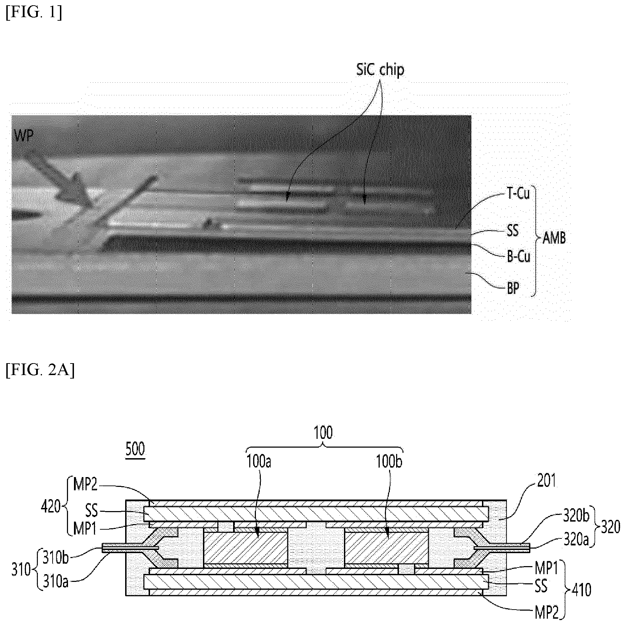

Meanwhile, FIG. 1 is a photograph of warpage (WP) occurring after the AMB heat dissipation substrate according to the prior art was bonded to the base plate (BP).

There is a significant difference in each coefficient of thermal expansion (CTE) of the insulating substrate, copper plate, and SiC for the heat dissipation substrate. For example, the thermal expansion coefficient of AlN insulation substrate SS is 4.5×10⁻⁶/°C, the thermal expansion coefficient of copper (T-Cu, B-Cu) is 16.0×10⁻⁶/°C, and the thermal expansion coefficient of SiC is 4.0 ×10⁻⁶/°C.

If warpage (WP) occurs due to differences in thermal expansion coefficients of the components that make up the power semiconductor module in an extremely high operating temperature environment of 300°C or higher, malfunction of the power semiconductor module may occur.

In the prior art, methods such as designing a heat sink or controlling the temperature of the coolant were used to prevent warpage from occurring due to differences in thermal expansion coefficients.

In the internal technology, research was conducted on the selection of materials for the insulating substrate and metal plate that make up the heat dissipation substrate. However, there was no research or thought to consider the thickness ratio of the insulating substrate, upper metal plate, and lower metal plate that make up the heat dissipation substrate.

Meanwhile, according to internal research, the problem that the distance between circuit patterns increases as the metal plate on the heat dissipation substrate becomes thicker has been studied. For example, when the thickness of the Cu plate was about 0.2 mm, the separation distance between circuit patterns was about 0.4 mm. However, when the thickness of the Cu plate is about 0.4mm, there is an issue in that the separation distance between circuit patterns is about 0.6mm.

In internal technology, the thickness of the metal plates bonded to the top and bottom of the heat dissipation substrate was managed within a certain thickness range, and when etching the metal plate, etching was performed to ensure an average separation distance.

Meanwhile, in order to implement high-performance power semiconductor devices, complex circuit patterns are required as multiple SiC power semiconductors are mounted on a heat dissipation substrate. Additionally, if the separation distance between circuit patterns is widened more than necessary, it is difficult to implement a high-density power semiconductor module.

Also, according to internal research, when performing transient liquid phase bonding (TLP), the metal plate material of the heat dissipation substrate may be used up to form IMC (intermetallic compound). Accordingly, the problem that the IMC bonding layer is not formed properly, resulting in lower bonding strength or pores, was studied.

However, in power semiconductor modules operating at extremely high temperatures, decreased adhesion between the power semiconductor device and the heat dissipation substrate or the presence of pores at the bonding interface may have a significant impact on performance degradation and reliability of the power semiconductor module.

In addition, in the conventional heat dissipation substrate industry, all production and quality information and history, such as the insulating substrate including ceramic substrate thickness information, inspection information, copper plate thickness information, surface information, and interface information after the bonding process, are not accurately matched and managed for each 'individual heat dissipation substrate'.

Meanwhile, in particular, when metal is sputtered on the insulating substrate and then a copper plate and hot press process are performed, even if a predetermined code is marked on the insulating substrate, the code is obscured by the sputtering process and the hot press process, so it was not possible to attempt to mark a separate code for each 'individual heat dissipation substrate'.

Meanwhile, internal technology relied on manual work for the insulating substrate and metal plate stacking process. Meanwhile, when the stacking process was carried out manually, it was difficult to consider matching the thickness of each the insulating substrate and metal plate, and even controlling the placement of the metal plate on the upper and lower sides of the ceramic substrate was not easy.

In particular, in the internal technology, the stacking set of the heat dissipation substrate includes an insulating substrate and a metal plate disposed on the top and bottom, and in realizing a high stacking degree of tens to close to 100 sets, the alignment of the insulating substrate and the metal plate was studied as a difficult technical challenge.

### SUMMARY

One of the technical objects of the embodiment is to solve the problem of difficulty in meeting the strict thickness specifications of the final heat dissipation substrate in a situation where the thickness of the technical challenge insulating substrate is not constant and the thickness of the technical challenge metal plate is also not constant.

In addition, one of the technical objects of the embodiment is to solve the problem of warpage of the heat dissipation substrate due to differences in thermal expansion coefficients of the insulating substrate, upper metal plate, and lower metal plate that make up the heat dissipation substrate.

In addition, in order to implement high-performance power semiconductor devices, complex circuit patterns are required as multiple SiC power semiconductors are mounted on a heat dissipation substrate. Accordingly, one of the technical objects of the embodiment is to solve the problem that it is difficult to implement a high-density power semiconductor module when the separation distance between circuit patterns is widened more than necessary.

Additionally, during transient liquid phase bonding (TLP), the metal plate material of the heat dissipation substrate may be used up to form an intermetallic compound (IMC). So, one of the technical objects of the embodiment is to solve the problem of lowering the bonding strength or generating pores due to the IMC bonding layer not being formed properly.

Additionally, one of the technical objects of the embodiment is to solve the problem of cracks occurring at the bonding interface of the heat dissipation substrate.

The technical objects of the embodiments are not limited to those described in this section, but include those that can be understood through the description of the invention.

Technical solutions for solving the technical problems according to the embodiment are as follows.
A heat dissipation substrate for a power semiconductor module according to an embodiment may include a first metal plate, an insulating substrate bonded to the first metal plate, and a second metal plate bonded to the insulating substrate, and a first thickness of the first metal plat may be different from a second thickness of the second metal plate.

The first thickness of the first metal plate may be thinner than the second thickness of the second metal plate.

The first metal plate may include a circuit pattern electrically connected to a predetermined power semiconductor device, and the second metal plate may include a marked unique code.

In addition, a heat dissipation substrate for a power semiconductor module according to an embodiment may include a second metal plate, an insulating substrate bonded to the second metal plate, and a third metal plate bonded to the insulating substrate. The third thickness of the third plate may be thicker than the second thickness of the second metal plate.

The third metal plate may include a circuit pattern electrically connected to a predetermined power semiconductor device, and the second metal plate may include a marked unique code.

The unique code may include thickness information of at least one of the insulating substrate or the first and second metal plates.

The embodiment may further include a unique ID marked on the first metal plate or the second metal plate.

A power semiconductor module according to an embodiment may include a first heat dissipation substrate, a power semiconductor device disposed on the first heat dissipation substrate, and a second heat dissipation substrate disposed on the power semiconductor device, the first heat dissipation substrate or the second heat dissipation substrate may include any one of the heat dissipation substrates for the power semiconductor module.

The first heat dissipation substrate or the second heat dissipation substrate may include a heat dissipation substrate for one of the power semiconductor modules, and the embodiment may further include a power semiconductor device bonded to the circuit pattern of the first metal plate.

Additionally, the embodiment may include a bonding layer bonded between a circuit pattern of the first metal plate and the power semiconductor device by any one of sintering bonding, soldering bonding, or ultrasonic bonding.

The first heat dissipation substrate or the second heat dissipation substrate may include a heat dissipation substrate for one of the power semiconductor modules, and the embodiment may further include a power semiconductor device bonded to the circuit pattern of the third metal plate.

Additionally, the embodiment may include a bonding layer bonded between the circuit pattern of the third metal plate and the power semiconductor device using a phase change bonding method.

Additionally, the power converter according to the embodiment may include any of the above power semiconductor modules.

In addition, the insulating substrate for a heat dissipation substrate according to the embodiment may include an effective area (AA) of the insulating substrate, a dummy area (DA) of the insulating substrate disposed outside the effective area (AA), and the dummy area (DA) of the insulating substrate may include a unique code UC marked on.

The embodiment may further include a unique ID marked on the dummy area (DA) of the insulating substrate.

The unique ID may include a combination of numbers, letters, or a combination of numbers and letters.

The unique code UC may include a rectangular or square shape.

A vertex of the unique code and a vertex of the valid area may be arranged to face each other.

A minimum distance between the unique code and the effective area (AA) of the insulating substrate may correspond to a distance between a vertex of the unique code and a vertex of the effective area.

The corners of the unique code UC may be arranged to face the vertices of the active area closest to the unique code.

A heat dissipation substrate according to an embodiment may include a first metal plate, an insulating substrate bonded to the first metal plate, and a second metal plate bonded to the insulating substrate.

A unique code marked on the first metal plate or the second metal plate may be included.

The second metal plate may be electrically connected to a predetermined power semiconductor device.

The unique code may be provided on the first metal plate.

The thickness of the first metal plate and the thickness of the second metal plate may be different from each other.

Additionally, the power semiconductor module according to the embodiment may include a first heat dissipation substrate, a power semiconductor device disposed on the first heat dissipation substrate, and a second heat dissipation substrate disposed on the power semiconductor device.

The first heat dissipation substrate or the second heat dissipation substrate may include one of the heat dissipation substrates for a power semiconductor module.

The second metal plate is electrically connected to the power semiconductor device, and the unique code may be provided on the first metal plate.

The thickness of the first metal plate and the thickness of the second metal plate may be different from each other.

Additionally, the power converter according to the embodiment may include any of the above power semiconductor modules.

The technical effects according to the embodiment are as follows.
According to the embodiment, there is a technical effect of preventing warpage of the heat dissipation substrate by controlling the respective thickness ratios of the insulating substrate, upper metal plate, and lower metal plate that constitute the heat dissipation substrate.

Also, according to the first heat dissipation substrate 410B of the second embodiment, a first thickness T1 of the first metal plate MP1 bonded on the first side of the insulating substrate SS facing the power semiconductor device 100 can be controlled to be less than or equal to the second thickness T2 of the second metal plate MP2 bonded on the second surface of the insulating substrate.

According to the second embodiment, since the first thickness T1 of the first metal plate MP1 bonded to the power semiconductor device 100 can be controlled to be thin, there is a technical effect of providing a high-density power semiconductor module by ensuring a compact separation distance PD between the first circuit patterns CP1 of the first metal plate MP1.

Additionally, according to the third embodiment, the third thickness T3 of the third metal plate MP3 bonded to the power semiconductor device 100 can be controlled to be thick. So, since the third thickness T3 of the third circuit patterns CP3 of the third metal plate MP3 can be controlled to be equal to or greater than the second thickness T2 of the second metal plate MP2, when conducting phase change bonding (Transient Liquid Phase Bonding) between the power semiconductor device 100 and the third metal plate MP3, the issue of exhaustion of the metal plate material of the heat dissipation substrate during the IMC formation process can be prevented. Therefore, the third embodiment has a special technical effect in improving bonding strength and solving the problem of pores occurring at the bonding interface.

Also, there is a technical effect in managing heat dissipation substrates by accurately matching and updating all production and quality information and history such as thickness information of insulating substrate such as a ceramic substrate, inspection information, thickness information of copper plate, surface information, bonding interface information after bonding process, etc. for each 'individual heat dissipation substrate'.

For example, according to an embodiment, unique information can be marked on the dummy area of the initial insulating substrate during the heat dissipation substrate manufacturing process, and the unique information can be stored and managed on a central server to store all production, so that, there is a special technical effect of being able to accurately match and update all production and quality information and history in the heat dissipation substrate manufacturing process by 'individual insulating substrate', 'individual metal plate', and 'individual heat dissipation substrate'.

In addition, according to the embodiment, even if the position or arrangement of the insulating substrate changes due to an operator's mistake during the manufacturing process, it is possible to check the unique information of the individual insulating substrate in all processes through application of the embodiment. And verifying the unique information of the insulating substrate, there is a technical effect of being able to completely update and manage the history of all processes, including the initial receipt of individual insulating substrates, cleaning stages, and hot pressing.

In addition, according to an embodiment, unique information that can confirm information about the history of all processes from the initial warehousing stage of the product can be perfectly matched to the final product and delivered to the customer, and the customer can also accurately understand and use the product quality and production history through the unique information, or make requests for after-sales service quickly and accurately when necessary.

Meanwhile, simply marking product information on the heat dissipation substrate of the final product cannot perfectly match and manage the film formation information, such as the thickness information of the insulating substrate that constitutes the product, the thickness information of the metal plate, and the bonding interface information.

In addition, according to the embodiment, there is a technical effect of minimizing thickness distribution by classifying individual insulating substrates and metal plates by thickness and matching them by thickness grade.

For example, according to the embodiment, insulating substrates may be classified and loaded into the first to third substrate magazines CM1, CM2, and CM3 according to thickness, and the thickness and classification loading information for 'individual insulating substrates' and 'individual substrate magazines' can be stored and managed on the upper server. In addition, the unique information UC of each insulating substrate SS can be precisely updated and managed with information about which substrate magazine it was loaded into.

Accordingly, in the stacking process conducted after the sputtering process, by reading the unique IDs of the first to third substrate magazines CM1, CM2, and CM3, there is a technical effect of optimizing the thickness quality of the heat dissipation substrate through matching stacking and bonding processes for each thickness with the metal plate.

In addition, the embodiment closely measures and manages the thickness of insulating substrates and copper plates delivered in various thicknesses to perfectly manage this thickness information so that it can be matched to each product through unique information, and there is a technical effect that can minimize thickness distribution based on this unique information.

For example, according to the embodiment, the thickness of insulating substrates and metal plates delivered in various thicknesses can be closely measured and managed. Accordingly, each thickness information can be completely updated and managed through unique information UC to match the specifications for each product required by each customer. In addition, based on this unique information UC, the optimal stacking set combination of the insulating substrate and metal plate can be calculated and hot press fixation can be performed after stacking. Accordingly, there is a special technical effect in providing a heat dissipation substrate that can perfectly meet strict thickness specifications, a power semiconductor module equipped with the same, and a stacking system of an insulating substrate and a copper substrate.

Additionally, the embodiment has the technical effect of providing an automatic alignment stacking device capable of automatic stacking and automatic alignment of insulating substrates and metal plates.

For example, according to the 'automatic alignment stacking system 800' according to the embodiment, automatic stacking and hot press bonding processes of dozens to over 100 sets are possible.

In particular, according to the embodiment, a bottom of the stacking unit 850 has a tilted structure, resulting in a special technical effect that enables precise automatic alignment of the edges of the sequentially stacked spacers, metal plates, and insulating substrates. For example, according to the embodiment, there is a special technical effect that can innovatively increase vertical alignment accuracy by using gravity through tilting stacking.

Accordingly, precise automatic alignment is possible as dozens of sets to over 100 sets are automatically stacked. In addition, even during the hot press joining process exceeding tens of tons, the alignment is maintained accurately and there is no distortion of the stacking set. So, there is a special technical effect that enables the implementation of high-quality heat dissipation substrates.

Also, according to the embodiment, there is a technical effect of solving the problem of cracks occurring at the bonding interface of the heat dissipation substrate. For example, according to the embodiment, cracks caused at the interface between the insulating substrate of the heat dissipation substrate and the copper sheet can be prevented from occurring, thereby improving the reliability of the power semiconductor device.

The technical effects of the embodiments are not limited to those described in this item and include those that can be understood through the description of the invention.

### BRIEF DESCRIPTION OF THE DRAWINGS

FIG. 1 is a photo of warpage occurring after the AMB heat dissipation substrate according to the prior art was bonded to the base plate (BP).
FIG. 2A. is a cross-sectional view of a power semiconductor module 500 including a heat dissipation substrate for power semiconductors according to an embodiment.
FIG. 2B is a manufacturing process diagram of a power semiconductor module 501 including a heat dissipation substrate for power semiconductor according to a first embodiment.
FIG. 2C is a manufacturing process diagram of a power semiconductor module 502 including a heat dissipation substrate for power semiconductor according to a second embodiment.
FIG. 2D is a manufacturing process diagram of a power semiconductor module 503 including a heat dissipation substrate for power semiconductor according to a third embodiment.
FIG. 3A is a first cross-sectional view of a power semiconductor device 100 according to an embodiment.
FIG. 3B is a second cross-sectional view of the power semiconductor device 100 according to an embodiment.
FIG. 4 is a process flow chart of a heat dissipation substrate manufacturing process for power semiconductors according to an embodiment.
FIGS. 5A to 8 are diagrams of a pretreatment process for an insulating substrate.
FIGS. 9 to 12 are diagrams of a sputtering process for an insulating substrate according to an example.
FIG. 13 is a view of a metal magazine MM in which metal plates classified by thickness are loaded.
FIGS. 14 and 15 are schematic diagrams of an automatic alignment stacking system 800 of an insulating substrate and a metal plate in an embodiment.
FIG. 16 is a flowchart of the stacking process of an insulating substrate and a metal plate.
FIG. 17 is conceptual diagram of a stacking set stacked within a stacking unit.
FIGS. 18 and 19B are diagrams of a hot press bonding process according to an embodiment.
FIG. 20 is an exemplary diagram of a heat dissipation substrate after an inspection process and an etching process.
FIGS. 21 to 22 are diagrams of a laser scribing process, inspection process, and cutting process for a heat dissipation substrate.
FIG. 23 is a circuit diagram of a power converter according to an embodiment.

### DETAILED DESCRIPTION

Hereinafter, embodiments are described in detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

In an embodiment, the power semiconductor module may be used in inverters or converters such as automobiles, computers, home appliances, solar power, and smart grids. In addition, the power semiconductor module according to the embodiment can be applied to various electrical and electronic devices such as electric differential car chargers, power supply devices, or railways, in addition to eco-friendly vehicles.

Also, in an embodiment, the heat dissipation substrate for power semiconductor may be also used in inverters or converters such as automobiles, computers, home appliances, solar power, and smart grids. In addition, the heat dissipation substrate for power semiconductor according to the embodiment can be also applied to various electrical and electronic devices such as electric differential car chargers, power supply devices, or railways, in addition to eco-friendly vehicles.

In the embodiment, a power semiconductor device may include one power semiconductor module or a plurality of power semiconductor modules. Additionally, the power semiconductor module may include a plurality of power semiconductor devices.

In the following embodiments, the power semiconductor device describes an automobile inverter for driving a motor, but the power semiconductor device of the embodiment can be applied to inverters or converters in the various technical fields described above. Here, vehicles include hybrid vehicles (HEV), plug-in hybrid vehicles (PHEV), electric vehicles (EV), and fuel cell vehicles (PCEV). In the description of the following embodiments, switching devices and power semiconductor devices may be used interchangeably.

### <Power semiconductor module including heat dissipation substrate>

FIG. 2A is a cross-sectional view of a power semiconductor module 500 including a heat dissipation substrate for a power semiconductor according to the embodiment. And FGI. 2B is a manufacturing process diagram of a power semiconductor module 501 including the heat dissipation substrate for power semiconductor according to the first embodiment.

Referring to FIG. 2A, the power semiconductor module 500 according to the embodiment may include a first heat dissipation substrate 410, a second heat dissipation substrate 420, a power semiconductor device 100, a first lead frame 310, a second lead frame 320 and, may be package by a mold 201, but is not limited to. The power semiconductor device 100 may include a first power semiconductor device 100a and a second power semiconductor device 100b.

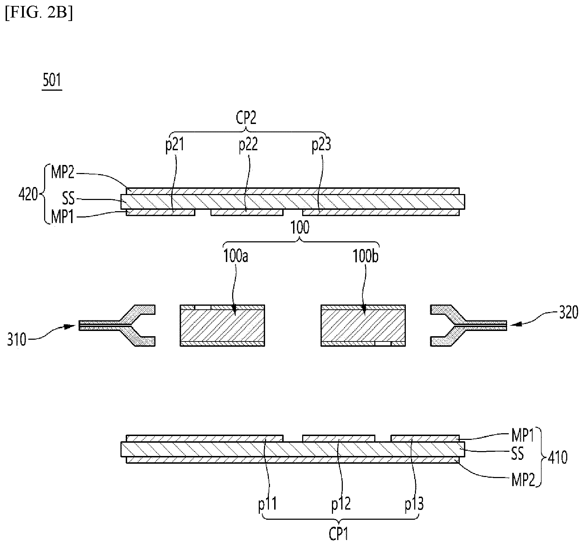

For example, referring to FIG. 2B, after the first lead frame 310, the second lead frame 320, and the single or plural power semiconductor devices 100a and 100b are disposed between the first heat dissipation substrate 410 and the second heat dissipation substrate 420, the power semiconductor module 501 according to the first embodiment may be manufactured by pressing them.

The power semiconductor device 100, the first heat dissipation substrate 410, and the second heat dissipation substrate 420 may be bonded through a predetermined adhesive member (not shown).

For example, the first and second heat dissipation substrates 410 and 420 may be bonded to the power semiconductor device 100 through soldering, sintering bonding, transient liquid phase bonding (TLP Bonding) or ultrasonic bonding.

For example, the power semiconductor device 100 may be bonded to the first and second heat dissipation substrates 410 and 120 through sintering bonding.

For example, the first and second heat dissipation substrates 410 and 420 may be bonded to the power semiconductor device 100 by screen printing a conductive paste such as Ag paste and then performing a sintering process at a temperature of about 150 to 300°C. The conductive paste may include conductive powder such as Ag, a solvent, and a binder.

Cu or Ag surface treatment may be performed on the heat dissipation substrate before the sintering bonding. Additionally, in the sintering bonding process, bonding strength can be improved through pressure bonding using a predetermined bonding jig.

Alternatively, the power semiconductor device 100 of the embodiment may be bonded to the first and second heat dissipation substrates 410 and 120 through transient liquid phase (TLP) Bonding.

The transient liquid phase in the embodiment is a bonding technology that forms IMC (intermetallic compound) based on diffusion at a predetermined temperature by inserting a thin metal piece between metal layers.

In the embodiment, materials for forming the IMC junction may include Cu-based, Ni-based, etc. For example, in an embodiment, the IMC junction may include any one of Cu-Sn, Ni-Sn, and Cu-Ni-Sn.

Alternatively, the power semiconductor device 100 of the embodiment may be bonded to the first and second heat dissipation substrates 410 and 220 through ultrasonic bonding technology.

The ultrasonic bonding technology of the embodiment applies a certain pressure to the power semiconductor device to be bonded and the heat dissipation substrate, and vibrates with a certain amount of ultrasonic waves, for example, about 20 kHz or higher, and causes contact between metals by rubbing the bonding surface, generating frictional heat. It is a technology to form junctions and join them by using, etc.

The ultrasonic bonding technology of the embodiment may include a vertical vibration method and a horizontal vibration method depending on the direction of vibration.

Referring again to FIG. 2A, in the power semiconductor module 500 according to the embodiment, the first power semiconductor device 100a and the second power semiconductor device 100b may form one arm. For example, the first power semiconductor device 100a and the second power semiconductor device 100b may be connected in series with electrodes arranged in opposite directions, but the present invention is not limited to this. For example, the first power semiconductor device 100a and the second power semiconductor device 100b may be electrically connected in parallel.

In the embodiment, the first and second heat dissipation substrates 410 and 420 may be disposed on the lower and upper sides of the power semiconductor module 500, respectively, but are not limited thereto.

The first heat dissipation substrate 410 may include a first metal plate MP1, an insulating substrate SS, and a second metal plate MP2.

The insulating substrate SS may electrically insulate the first metal plate MP1 and the second metal plate MP2. The insulating substrate SS may include a polycrystalline insulating substrate made of a ceramic material with high thermal conductivity. For example, the insulating substrate SS may be one of AlN or Si₃N₄, but is not limited thereto, and may also include Al₂O₃. Additionally, the insulating substrate SS may include a single crystal substrate such as a sapphire substrate.

Hereinafter, the insulating substrate SS will be described as an example of a polycrystalline substrate made of ceramic material, but is not limited thereto and may also include a single crystalline substrate.

The first metal plate MP1 and the second metal plate MP2 may include Cu-based metal, but are not limited thereto.

One side of the second metal plate MP2 is in contact with the insulating substrate SS and can radiate heat to the other side. A heat dissipation means including a cooling medium may be disposed close to the other side of the second metal plate MP2.

Referring to FIG. 2b, the first metal plate MP1 disposed on the lower side of the power semiconductor device 100 may include a first circuit pattern CP1 formed by a patterning process such as etching. The first circuit pattern CP1 may be electrically connected to the electrodes of the power semiconductor device 100.

For example, the first circuit pattern CP1 includes an electrically separated first-first circuit pattern p11, a first-second circuit pattern p 12, and a first-third circuit patternp13 and may be electrically connected to the first power semiconductor device 100a and the second power semiconductor device 100b, respectively, as shown in FIG. 2A.

Additionally, the second heat dissipation substrate 420 may also include a first metal plate MP1, an insulating substrate SS, and a second metal plate MP2. The second heat dissipation substrate 420 may adopt the technical features of the first heat dissipation substrate 410.

For example, the first metal plate MP1 disposed on the power semiconductor device 100 may be formed through a patterning process such as etching and may include an electrically separated second circuit pattern CP2. The second circuit pattern CP2 may include a second-first circuit pattern p21, a second-second circuit pattern p22, and a second-third circuit pattern p23, and may be electrically connected to the first power semiconductor device 100a and the second power semiconductor device 100b as shown in FIG. 2A.

Continuing to refer to FIG. 2A, one side of each of the first lead frame 310 and the second lead frame 320 may be electrically connected to the power semiconductor device 100, and the other side of each may be externally be connected to the terminal. External connection terminals may include input power, motors, or inverter controllers.

For example, the first lead frame 310 and the second lead frame 320 may be electrically connected to the power semiconductor device 100 through the first heat dissipation substrate 410 and the second heat dissipation substrate 420. You can.

For example, the first lead frame 310 includes a first-first lead frame 310a electrically connected to the first-first circuit pattern p11 of the lower first metal plate MP1 and may include a first-second lead frame 310b electrically connected to the second-first circuit pattern p21 of the upper first metal plate MP1.

In addition, the second lead frame 320 includes a second-first lead frame 320a electrically connected to the first-third circuit pattern p 13 of the lower first metal plate MP1, and may include a second-second lead frame 320b electrically connected to the second-third circuit pattern p23 of the metal plate MP1.

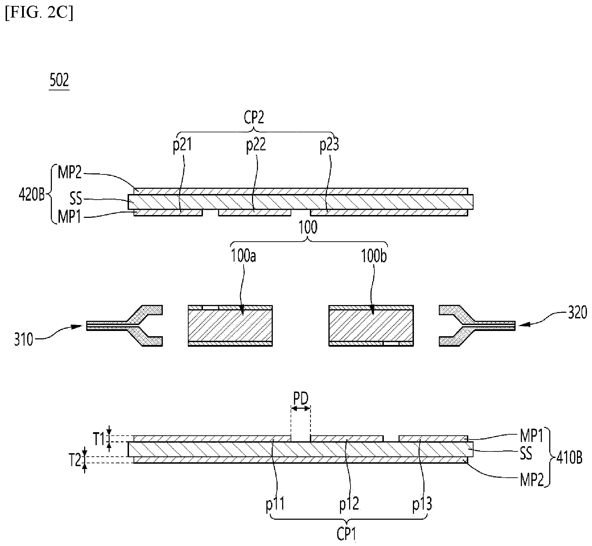

Next, FIG. 2C is a manufacturing process diagram of the power semiconductor module 502 including a heat dissipation substrate for power semiconductor according to the second embodiment.

The power semiconductor module 502 including the heat dissipation substrate for power semiconductors according to the second embodiment may adopt the technical feature of the power semiconductor module 501 including the heat dissipation substrate for power semiconductors according to the first embodiment described above, and the description will focus on the technical features of the second embodiment below.

According to internal research, the problem of increasing the distance between circuit patterns as the thickness of the metal plate on the heat sink board was studied.

For example, when the thickness of the Cu plate is about 0.2mm, the separation distance between circuit patterns is about 0.4mm, whereas when the thickness of the Cu plate is about 0.4mm, there is issue of the separation distance between circuit patterns being about 0.6mm.

In internal technology, the thickness of the metal plates bonded to the top and bottom of the heat dissipation substrate was managed to a certain thickness, and etching was performed to ensure an average separation distance when etching the metal plates.

Meanwhile, in order to implement high-performance power semiconductor devices, complex circuit patterns are required as multiple SiC power semiconductors are mounted on a heat dissipation substrate. And if the separation distance between circuit patterns is widened more than necessary, it is difficult to implement high-density power semiconductor modules

Accordingly, the inventors of this application can control the thickness of the metal plate on one side of the heat dissipation substrate on which the circuit pattern is formed to be different from the thickness of the metal plate on the other side. Control of the metal plate thickness will be described in detail later.

Referring to FIG. 2C, in the power semiconductor module 502 according to the second embodiment, the first heat dissipation substrate 410B of the second embodiment may include a first metal plate MP1 with a first thickness (T1) on one side of the insulating substrate SS and facing the power semiconductor device 100 and a second metal plate MP2 with a second thickness T2 on the second side of the insulating substrate.

In the second embodiment, the first thickness T1 of the first metal plate MP1 may be less than or equal to the second thickness T2 of the second metal plate MP2.

For example, in the second embodiment, the first thickness T1 of the first metal plate MP1 may be less than the second thickness T2 of the second metal plate MP2.

According to the first heat dissipation substrate 410B of the second embodiment, the first thickness T1 of the first metal plate MP1 bonded on the first surface of the insulating substrate SS facing the power semiconductor device 100 can be controlled to be less than or equal to the second thickness T2 of the second metal plate MP2 bonded on the second surface of the insulating substrate.

Additionally, the second heat dissipation substrate 420B of the second embodiment may also adopt the technical features of the first heat dissipation substrate 410B of the second embodiment.

According to the second embodiment, the first thickness T1 of the first metal plate MP1 bonded to the power semiconductor device 100 can be controlled to be thin, so there is a technical effect of providing a high-density power semiconductor module by ensuring a compact separation distance PD between the circuit patterns CP1.

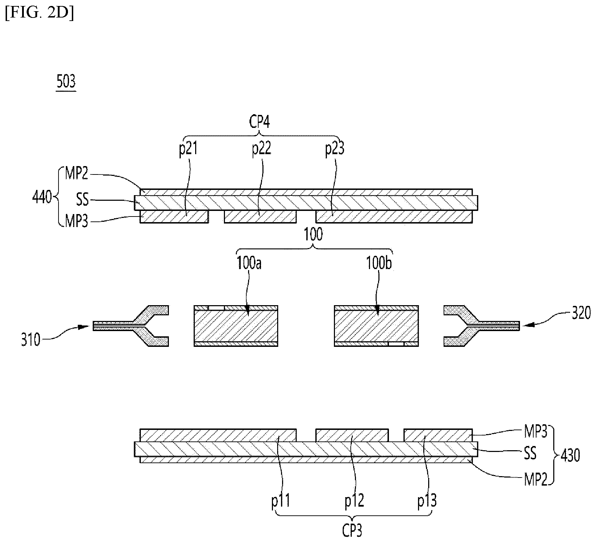

Next, FIG. 2D is a manufacturing process diagram of the power semiconductor module 503 including a heat dissipation substrate for power semiconductor according to the third embodiment.

The power semiconductor module 503 including the heat dissipation substrate for power semiconductors according to the third embodiment may adopt the technical feature of the power semiconductor module 501 including the heat dissipation substrate for power semiconductors according to the first embodiment described above and the description will focus on the technical features of the third embodiment below.

According to an internal study, during transient liquid phase bonding TLP, as the metal plate material of the heat dissipation substrate is used up to form IMC (intermetallic compound), the IMC bonding layer is not formed properly. So, there is a problem in that the bonding strength decreases or porosity occurring.

However, in power semiconductor modules operating at extremely high temperatures, a decrease in the adhesion between the power semiconductor device and the heat dissipation substrate or the presence of pores at the bonding interface may have a significant impact on the performance degradation and reliability of the power semiconductor module.

Accordingly, the inventors of this application can control the thickness of the metal plate on one side of the heat dissipation substrate on which the circuit pattern is formed to be different from the thickness of the metal plate on the other side.

For example, referring to FIG. 2D, in the power semiconductor module 503 according to the third embodiment, the third heat dissipation substrate 430 may include a third metal plate MP3 with a third thickness T3 bonded on one side of the third of the insulating substrate SS and facing the power semiconductor device 100 and a second metal plate MP2 with a second thickness T2 bonded on the second side of the insulating substrate.

In the third embodiment, the third thickness T3 of the third metal plate MP3 may be greater than or equal to the second thickness T2 of the second metal plate MP2.

For example, in the third embodiment, the third thickness T3 of the third metal plate MP3 may exceed the second thickness T2 of the second metal plate MP2.

According to the third embodiment, the third thickness T3 of the third metal plate MP3 bonded on the first side of the insulating substrate SS facing the power semiconductor device 100 can be controlled to be equal to or greater than the second thickness T2 of the second metal plate MP2 bonded on the second surface of the substrate.

According to the third embodiment, the third thickness T3 of the third metal plate MP3 bonded to the power semiconductor device 100 can be controlled to be thick, and accordingly, the third thickness T3 of the circuit patterns CP3 is also controlled to be equal to or greater than the second thickness T2 of the second metal plate MP2. So, when conducting transient liquid phase bonding between the power semiconductor device 100 and the third metal plate MP3, the issue of exhaustion of the metal plate material of the heat dissipation substrate during the IMC formation process can be prevented. Accordingly, there is a special technical effect that can improve bonding strength and solve the problem of pores occurring at the bonding interface.

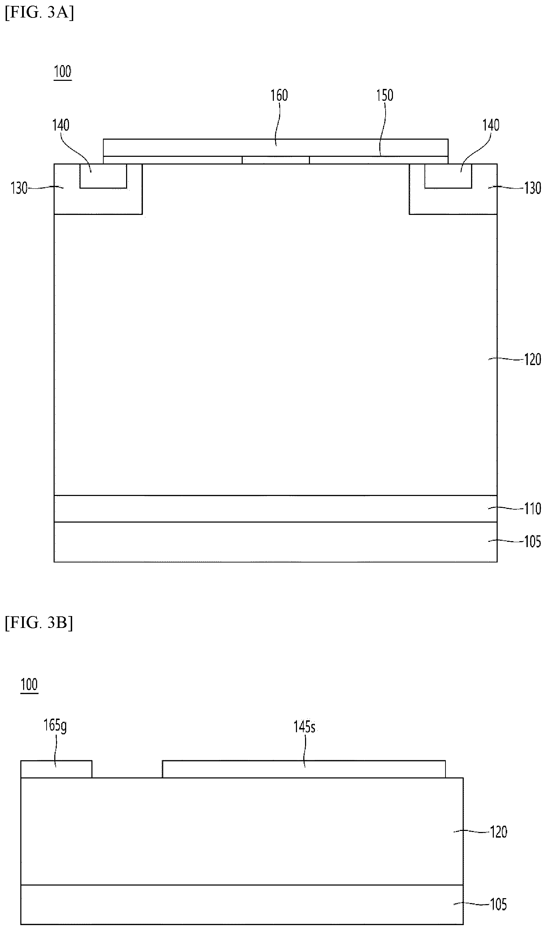

Next, FIG. 3A is a first cross-sectional view of the power semiconductor device 100 according to an embodiment.

Referring to FIG. 3A, the power semiconductor device 100 according to the embodiment includes a substrate 110, a first conductivity type epi layer 120, a second conductivity type well 130, a first conductivity type source region 140, a gate insulating layer 150, a gate electrode 160, and a drain electrode 105. The first conductivity type may be N-type, and the second conductivity type may be P-type, but are not limited thereto.

For example, the power semiconductor device 100 includes a first conductive epitaxial layer 120 formed on a predetermined substrate 110, a second conductive well 130 formed in the first conductive epitaxial layer 120, a first conductive type source region 140 formed in the second conductive well 130, and a gate insulating layer 150 and a gate electrode 160 on the first conductive type source region 140, and a drain electrode 105 disposed below the substrate 110.

The substrate 110 and the first conductive epitaxial layer 120 may include SiC (Silicon Carbide), but are not limited to,

Next, FIG. 3B is a second cross-sectional view of the power semiconductor device 100 according to an embodiment, and is a schematic diagram based on the first cross-sectional view shown in FIG. 3A.

The power semiconductor device 100 according to the embodiment includes a source electrode 145s disposed above a predetermined semiconductor epitaxial layer 120, a gate electrode 165g, and a drain electrode 105 disposed below the semiconductor epitaxial layer 120.

In the form of a MOSFET, the source electrode 145s or the gate electrode 165g may include an Al-based metal, and the drain electrode 105 may be a Ti/Ni/Ag meatle layer including a Ti layer, a Ni layer, and an Ag layer or may include NiV/Ag, V(vanadium)/Ni/Ag, etc., but is not limited thereto.

### <Manufacturing process of heat dissipation substrate for power semiconductors>

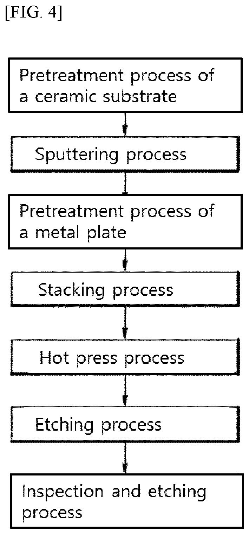

FIG. 4 is a schematic process flow chart of a manufacturing process for a heat dissipation substrate for a power semiconductor according to an embodiment.

The manufacturing process of a heat dissipation substrate for a power semiconductor according to the embodiment may include steps of ① a pretreatment process of an insulating substrate, ② a sputtering process, ③ a metal plate pretreatment process, ④ a stacking process of an insulating substrate and a metal plate, ⑤ a hot press process of an insulating substrate and a metal plate, ⑥ an etching process of the heat dissipation substrate, ⑦ inspection and cutting process of the heat dissipation substrate, etc.

The overall manufacturing process of the heat dissipation substrate for power semiconductors according to the embodiment may be controlled by a control unit (not shown) of a central server, and the central server may include a data storage unit (not shown).

Hereinafter, the main manufacturing process of the heat dissipation substrate for power semiconductors according to the embodiment will be described with reference to the drawings.

### (Pre-treatment process of insulating substrate)

The insulating substrate for manufacturing a heat dissipation substrate according to the following example will be described as an example of a polycrystalline ceramic substrate, but is not limited thereto, and may include a single crystal substrate such as a sapphire substrate.

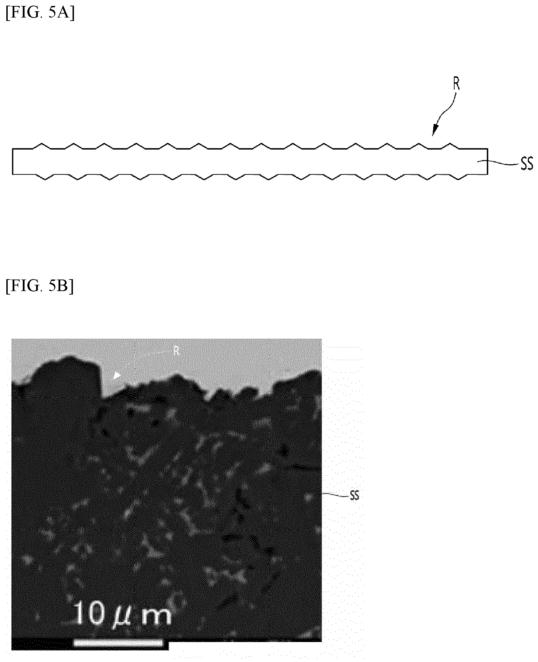

Hereinafter, the pretreatment process of the insulating substrate will be described with reference to FIGS. 5A to 8.

In the embodiment, the `pretreatment process for an insulating substrate' may be performed in a substrate cleaning device (not shown) before the ` stacking process' of the insulating substrate and the metal plate.

The pretreatment process of the insulating substrate may include ① a loading step of the insulating substrate, ② an unique code UC marking process, ③ a cleaning process of the insulating substrate, ④ a thickness measurement process of the insulating substrate, and (5) a loading process into a magazine for each thickness of the insulating substrate.

### ① Loading step of insulating substrate

First, as shown in FIG. 5A, the predetermined insulating substrate SS may be prepared and loaded into the ceramic cleaning device (not shown). The insulating substrate SS may be AlN, Si₃N₄, or Al₂O₃, but is not limited thereto. The insulating substrate SS may have irregularities R on its surface, but is not limited thereto, and may also include a single crystal substrate such as a sapphire substrate.

Meanwhile, FIG. 5B is a photograph showing unevenness R on the surface of the insulating substrate SS in the internal technology.

On the surface of the insulating substrate SS, unevenness R ranging in size from several µm to hundreds of µm may exist. These unevenness R may cause pores to occur during the bonding process when using conventional technology.

Referring to FIG. 5B, in the prior art or internal technology, the occurrence of pores was considered more unavoidable due to the unevenness R of several µm to hundreds of µm in size present on the surface of the insulating substrate. However, considering the extremely high operating temperature environment of power semiconductor modules, a solution must be prepared.

### (2) Unique code UC marking process

In the conventional heat dissipation substrate industry, it was difficult to accurately match overall production and quality history, such as insulating substrate thickness information, copper plate thickness information, and product information after the bonding process, `for each heat dissipation substrate.'

In particular, when metal sputtering is performed on the insulating substrate to which present invention is applied, followed by a copper plate and hot press process, even if the code is marked on the insulating substrate, etc., the code is obscured by the sputtering process and the hot press process. So that there was no attempt to mark separate code for each 'individual heat dissipation substrate'.

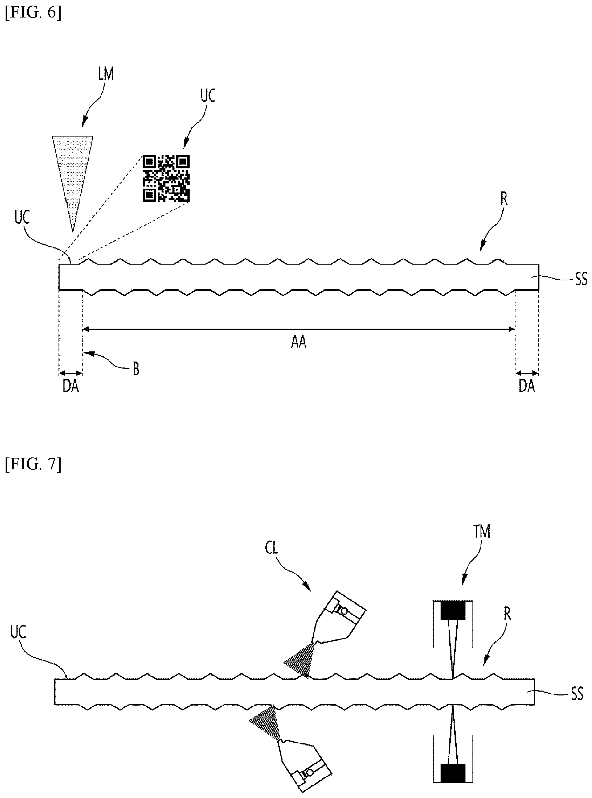

Referring to FIG. 6, the unique code UC may be marked on the insulating substrate SS loaded in the substrate cleaning device. Afterwards, the unique code UC is read, transmitted and stored wired or wirelessly to the data storage unit of the server, and detailed information on the 'individual heat dissipation substrate' including the 'individual insulating substrate' in the subsequent process can be precisely updated and managed.

Referring to FIG. 6, the insulating substrate SS may include an active area AA and a dummy area DA. The outermost edge of the active area AAmay be the boundary (B) between the active area AA and the dummy area DA.

The active area AA is the area that will be used in the final heat dissipation substrate product in the future, and the dummy area DA is the area that will be removed. The unique code UC may be marked on the dummy area DA of the insulating substrate SS.

The unique code UC may include, but is not limited to, a digital matrix code (DMC), a QR code, or a bar code. For example, the unique code UC may include a unique code marked or labeled by unique code technology that may emerge through technological development after the application of present invention.

Additionally, the unique code UC may be marked by laser marking (LM) technology, but is not limited thereto.

According to the embodiment, after marking a unique code UC and a unique ID for the entire inserted insulating substrate SS, it can be transmitted and managed to the data storage of the upper server, detailed information on the 'individual insulating substrate' and the 'individual heat dissipation substrate' including it can be precisely updated and managed, and there is also a special technical effect that enables post-event management between processes.

In the heat dissipation substrate industry, there has been no concern or attempt to manage the process history of the heat dissipation substrate manufacturing process for individual insulating substrates.

Meanwhile, the inventors of this application discovered that in the new research process of process history management of the manufacturing process for 'individual insulating substrates' in the field of heat dissipation substrates, when marking the unique code on an insulating substrate, a unique problem was discovered in which burning occurred and the burning could spread beyond the dummy area DA to the active area AA.

This unique technical problem was studied in that burning can cause sputtering defects in the later sputtering process, which can be directly related to the quality of the heat dissipation substrate itself, and can further cause bonding defects in the metal plate and hot press process.

Accordingly, not only was it difficult to think of marking a certain unique code on the insulating substrate itself, but there were significant technical difficulties in implementing it.

Nevertheless, the inventors of this application independently studied the point that burning does not affect the active area when marking the unique code UC, and precisely marked the unique code UC in the dummy area DA without burning.

In addition, in present invention, marking a unique code on an insulating substrate causes the unique code to be obscured in the sputtering process and hot press process, so attempts to mark a unique code on an individual insulating substrate were technically difficult.

### ③ Cleaning process of the insulating substrate and ④ Thickness measurement process

Next, referring to FIG. 7, a cleaning process and a thickness measurement process for the insulating substrate SS may be performed.

For example, a CDA (Clean Dried Air) cleaning process CL may be performed on the insulating substrate SS.

In addition, in the example, after cleaning the insulating substrate SS, the thickness of 9 points can be measured using a displacement sensor TM, etc., but it is not limited to this.

The thickness of the insulating substrate SS may be 200µm~1,000µm, but is not limited thereto. Preferably, the thickness of the insulating substrate SS may be 300µm~800µm, but is not limited thereto.

Insulating substrates SS can be classified into a plurality of groups depending on their thickness. For example, the insulating substrate SS may be classified into first to third group insulating substrates depending on the thickness of the insulating substrate SS, but is not limited thereto.

### ⑤ Loading process according to the thickness of the insulating substrate

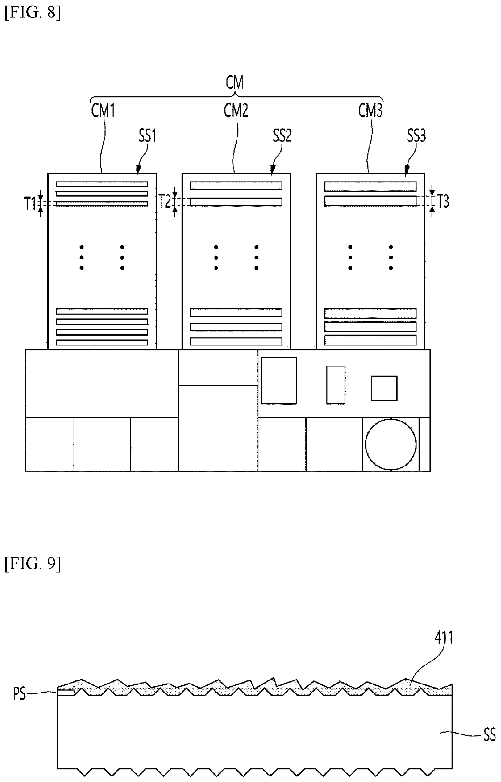

FIG. 8 is a diagram of a substrate magazine CM in which insulating substrates classified by thickness after cleaning are loaded according to an embodiment.

For example, insulating substrates may be classified into first to third groups of insulating substrates SS1, SS2, and SS3 according to first to third thicknesses T1, T2, and T3.

For example, the thickness of the first group insulating substrate SS1, the second group insulating substrate SS2, and the third group insulating substrate SS3 may be thick in that order, but the thickness is not limited thereto.

The first to third groups of insulating substrates SS1, SS2, and SS3 may be loaded into the first to third substrate magazines CM1, CM2, and CM3, respectively, and then transferred to a predetermined stacking device. The first to third groups of insulating substrates may be referred to as first to third lots.

In the embodiment, each of the first to third substrate magazines CM1, CM2, and CM3 may also be marked with a predetermined unique ID or unique code.

According to the embodiment, an insulating substrate may be classified and loaded into the first to third substrate magazines CM1, CM2, and CM3 according to thickness, and thickness and classification loading information for 'individual insulating substrates' and 'individual substrate magazines' can be stored and managed on the upper server.

In addition, the unique code UC of each insulating substrate SS can be precisely updated and managed with information about which substrate magazine it was loaded into.

Accordingly, in the stacking process performed after the sputtering process, by reading the unique IDs of the first to third substrate magazines CM1, CM2, and CM3, the thickness quality of the heat dissipation substrate can be optimized through matching stacking and bonding processes for each thickness with the metal plate.

According to the embodiment, there is a technical effect of minimizing thickness distribution by classifying individual insulating substrates and metal plates by thickness and matching them by thickness grade.

Currently, in the field of heat dissipation substrates, the thickness of supplied insulating substrates is not constant, and the thickness of supplied metal plates, such as copper plates, is also not constant.

In this situation, the final heat dissipation substrate must comply with the strict specifications for heat dissipation substrate delivery standards, but there are many difficulties in producing heat dissipation substrate that can meet the strict thickness specifications.

Accordingly, the inventors of present invention invented a stacking system of insulating substrates and copper substrates which closely measure and manage the thickness of insulating substrates and copper plates delivered in various thicknesses and perfectly manage this thickness information so that it can be matched to each product through unique information UC, and based on this unique information UC, thickness distribution can be minimized.

### (Sputtering process)

As described above, the insulating substrates classified by thickness can be transferred to the sputtering device while loaded in the first to third substrate magazines CM1, CM2, and CM3, and are unloaded for each individual insulating substrate and then the insulating substrates may be mounted on a sputtering device and the sputtering process may proceed.

Hereinafter, with reference to FIGS. 9 to 12, the 'sputtering process for an insulating substrate' of the embodiment will be described.

Referring to FIG. 9, a bonding metal layer 411 of a first thickness may be formed on one surface of the insulating substrate SS by sputtering.

At this time, sputtering may not be performed in the unique code UC and unique ID areas. For example, in the sputtering process, the unique code UC and the unique ID areas are covered and protected by sprayed parts PS, etc., and then sputtering may be controlled not to proceed in the unique code UC and unique ID areas.

For example, unlike the example shown in FIG. 9, the embodiment may control sputtering to not proceed even on the sprayed parts PS.

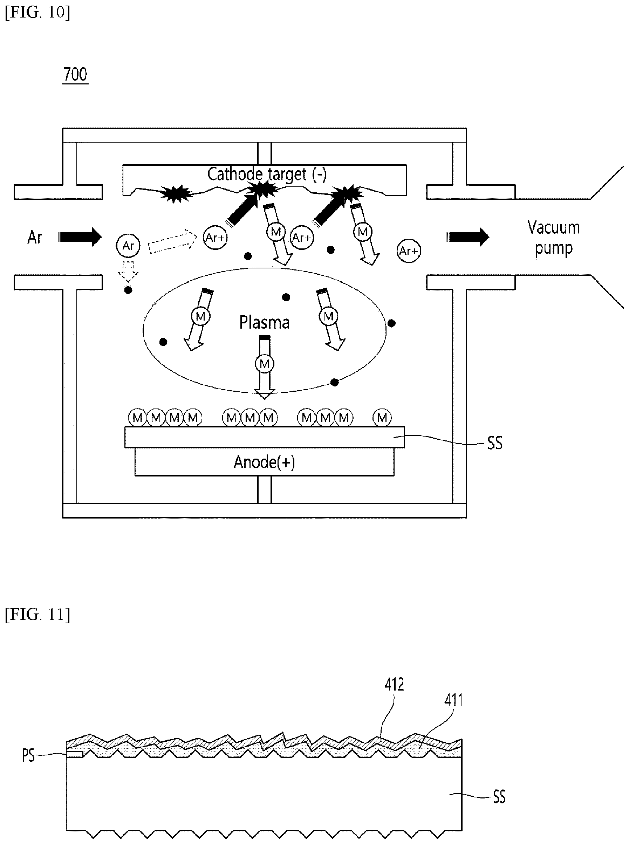

For example, referring to FIG. 10, an insulating substrate SS is mounted on the anode of a PVD equipment 700, and may be deposited with the bonding metal layer 411 containing Ti or TiW to a first thickness of 2,000Å to 4,000Å in an inert atmosphere such as Ar gas.

For example, the bonding metal layer 411 can be deposited to a thickness of about 2,500Å to 3,500Å, but is not limited thereto.

Next, referring to FIG. 11, the bonding metal layer 411 and the diffusion metal layer 412 may be formed by sputtering. The diffusion metal layer 412 may be deposited to a second thickness thinner than a first thickness of the bonding metal layer 411 by sputtering.

For example, the second thickness of the diffusion metal layer 412 may range from 1/4 to 1/2 the first thickness of the diffusion metal layer 411.

For example, the second thickness of the diffusion metal layer 412 may be about 1,000 Å or less to 2,000 Å. Preferably, the second thickness of the diffusion metal layer 412 may be about 1,500 Å to 1,900 Å, but is not limited thereto.

The diffusion metal layer 412 may have a melting point lower than the temperature of hot-pressing process for bonding. For example, the temperature of the hot press may range from about 900°C to 1100°C, and the diffusion metal layer 412 may be a material that has a melting point of less than 900°C and has excellent diffusion properties. For example, the diffusion metal layer 412 may be any one or more of Al, Ag, Au, and Sn, but is no limited thereto.

MP2Additionally, in the embodiment, sputtering may be performed with the anode electrode plate of FIG. 10 in a tilted state. Through this, it is possible to control the diffusion metal region 412a to be formed in the form of islands spaced apart from each other while first filling the bottom and sides of the concave portions of the surface irregularities of the bonding metal layer 411.

The diffusion metal region 412a may be formed to a third thickness that is much thinner than the first thickness of the bonding metal layer 411, which is 1/10 to 1/4 the thickness. For example, the third thickness of the diffusion metal region 412a may be about 200Å to 1,000Å. Preferably, the third thickness of the diffusion metal region 412a may be about 500Å to 900Å, but is not limited thereto.

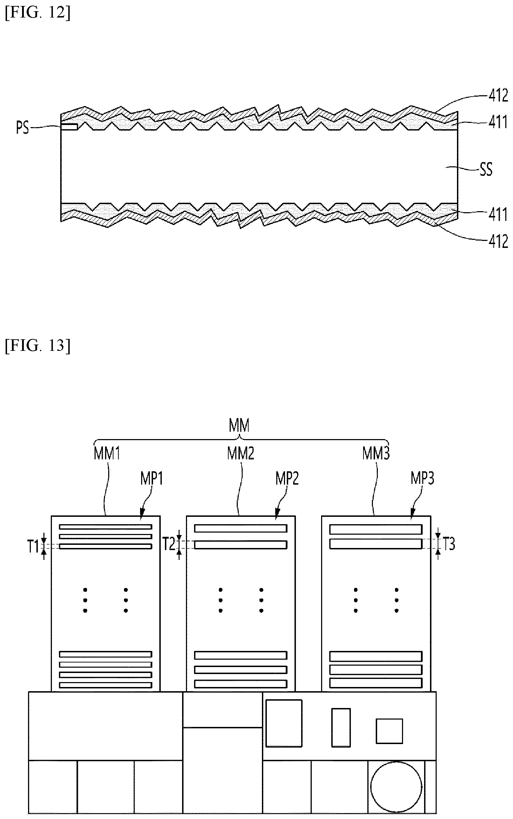

Next, referring to FIG. 12, after flipping the insulating substrate SS on which the diffusion metal layer 412 has been deposited on one surface, the bonding metal layer 411 and the diffusion metal layer 412 can be sequentially formed on the opposite surface by sputtering.

In the embodiment, the thickness of the bonding metal layer 411 and the diffusion metal layer 412 for each individual insulating substrate SS are measured after sputtering, and the thickness data for each unique code UC is transmitted to the server for update management.

For example, in the embodiment, the thickness of the deposited bonding metal layer 411 and the diffusion metal layer 412 may be measured by measuring the sheet resistance of the individual insulating substrate SS, but the present invention is not limited thereto.

The individual insulating substrates for which the thicknesses of the bonding metal layer 411 and the diffusion metal layer 412 have been measured can be transferred to the stacking device loaded again into the first to third substrate magazines CM1, CM2, and CM3, and the thickness of each insulating substrate and each metal plate can be matched and then stacked in a stacking device.

### (Metal plate pretreatment process)

FIG. 13 is a diagram of a metal magazine MM in which metal plates classified by thickness after cleaning are loaded according to an embodiment.

The metal plate pretreatment process may be performed separately from the insulating substrate pretreatment process. For example, the metal plate pretreatment process may be performed before, after, or simultaneously with the insulating substrate pretreatment process.

The metal plate may be a metal plate with excellent electrical conductivity and thermal conductivity. For example, the metal plate may be a Cu plate or a Cu alloy plate, but is not limited thereto. The metal plate may also be referred to as a metal substrate.

The metal plate pretreatment process may include a cleaning process and a thickness measurement process for the metal plate, and then the metal plates classified by each thickness category may be classified and loaded into a metal magazine.

For example, a CDA (Clean Dried Air) cleaning process and particle exhaust process for the metal plate may be performed.

Additionally, in the embodiment, after cleaning the metal plate, the top/bottom thickness of the metal plate can be measured using a displacement sensor, etc. For example, the thickness of 9 points of a metal plate can be measured, but the method is not limited to this.

At this time, the embodiment may transmit information about the metal plate thickness to the upper server, so that information about individual metal plates may be precisely updated and managed.

Additionally, in the embodiment, a marking procedure for metal-specific information (not shown) may be performed on the dummy area of the metal plate before cleaning, but the process is not limited to this.

In the embodiment, the thickness of the metal plate may be 200µm~500µm, but is not limited thereto. Preferably, the thickness of the metal plate may be 250µm~350µm, but is not limited thereto.

The metal plates may be classified into multiple groups depending on their thickness. For example, the metal plates may be classified into first to third metal plates MP1, MP2, MP3 depending on their thickness, but are not limited thereto. The thickness of the first metal plate MP1, the second metal plate MP2, and the third metal plate MP3 may be increased in that order, but the thickness is not limited to this.

For example, referring to FIG. 13, the first to third groups of metal plates MP1, MP2, and MP3 classified into the first to third thicknesses T1, T2, and T3 are respectively loaded into the first to third metal magazines MM1, MM2, and MM3 and then transferred to a predetermined stacking device. The first to third groups of the metal plates may be referred to as first to third lots.

In the embodiment, each first to third metal magazine MM1, MM2, MM3 may be marked with a predetermined unique ID or unique code.

According to the embodiment, the metal plates may be classified and loaded into first to third metal magazines MM1, MM2, and MM3 according to thickness, and thickness and classification loading information for individual metal plates and metal magazines can be stored and managed on the upper server.

In addition, the unique information of each metal plate can be precisely updated and managed with information about which metal magazine it was loaded into.

Accordingly, in the subsequent stacking process, the unique IDs of the first to third metal magazines MM1, MM2, and MM3 can be read and the thickness quality can be optimized through matching bonding for each thickness with the insulating substrate.

According to the embodiment, there is a technical effect of classifying not only individual insulating substrates but also metal plates by thickness and minimizing thickness distribution by matching each thickness grade.

Currently, in the field of heat dissipation substrates, not only the thickness of supplied insulating substrates but also the thickness of supplied metal plates, such as copper plates, is inconsistent. In this situation, the final heat dissipation substrates must comply with the strict specifications for heat dissipation substrates delivery standards, but there are many difficulties in producing heat dissipation substrates that can meet the strict thickness specifications.

Accordingly, the inventors of present invention closely measure and manage the thickness of insulating substrates and copper plates delivered in various thicknesses to perfectly manage this thickness information so that it can be matched to each product through unique information. Based on this unique information, a stacking system of insulating substrates and copper substrates that can minimize thickness distribution was invented.

For example, according to the embodiment, it is possible to comply with the strict specifications of heat dissipation substrate delivery standards by one laminated set including the second insulating substrate SS2 having a second thickness T2, the second metal plate MP2 having a second thickness T2 as the upper plate, and the second metal plate MP2 having a second thickness T2 as the lower plate.

For example, according to the embodiment, it is possible to comply with the strict specification heat dissipation substrate delivery standards by providing one laminated set including the second insulating substrate SS2 of second thickness T2, the first metal plate MP1 of first thickness T1 as the upper plate, and the second metal plate MP2 of the second thickness T2 as a lower plate.

Or for example, according to the embodiment, it is possible to comply with the strict specification heat dissipation substrate delivery standards by providing one laminated set including the second insulating substrate SS2 of second thickness T2, the first metal plate MP1 of a first thickness T1 as the upper plate, and the third metal plate MP3 of the third thickness T3 as a lower plate.

Or for example, according to the embodiment, it is possible to comply with the strict specification heat dissipation substrate delivery standards by providing one laminated set including the first insulating substrate SS1 of first thickness T1, the first metal plate MP1 of a first thickness T1 as the upper plate, and the third metal plate MP3 of the third thickness T3 as a lower plate.

Or for example, according to the embodiment, it is possible to comply with the strict specification heat dissipation substrate delivery standards by providing one laminated set including the first insulating substrate SS1 of first thickness T1, the second metal plate MP2 of a second thickness T2 as the upper plate, and the third metal plate MP3 of the third thickness T3 as a lower plate.

Or for example, according to the embodiment, it is possible to comply with the strict specification heat dissipation substrate delivery standards by providing one laminated set including the third insulating substrate SS3 of third thickness T3, the first metal plate MP1 of first thickness T1 as the upper plate, and the first metal plate MP1 of the first thickness T1 as a lower plate.

Or for example, according to the embodiment, it is possible to comply with the strict specification heat dissipation substrate delivery standards by providing one laminated set including the third insulating substrate SS3 of third thickness T3, the first metal plate MP1 of first thickness T1 as the upper plate, and the second metal plate MP2 of the second thickness T2 as a lower plate.

According to the embodiment, the thickness of insulating substrates and metal plates delivered in various thicknesses can be carefully measured and managed, and each thickness information can be completely updated to match the product specifications required by each customer through unique information UC. Accordingly, based on this unique information UC, the optimal stacking set combination of the insulating substrate and metal plate can be calculated and the hot press process can be performed after stacking. Therefore, there is a special technical effect in providing a heat dissipation substrate that can perfectly meet strict thickness specifications, a power semiconductor module equipped with the same, and a stacking system of an insulating substrate and a copper substrate.

### (Stacking process of insulating substrate and metal plate)

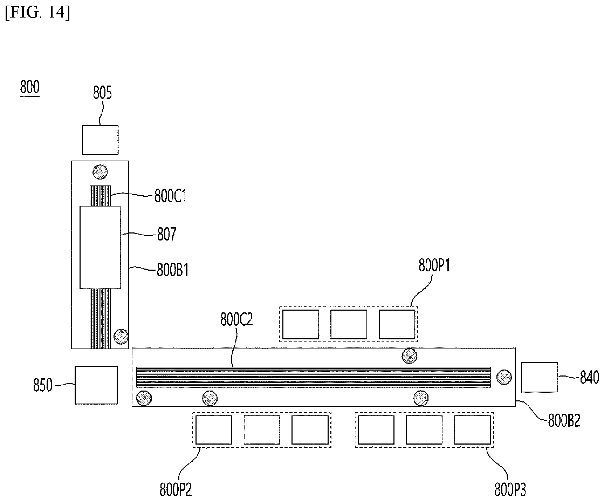

Next, the stacking process of the insulating substrate and the metal plate will be described with reference to FIGS. 14 to 16.

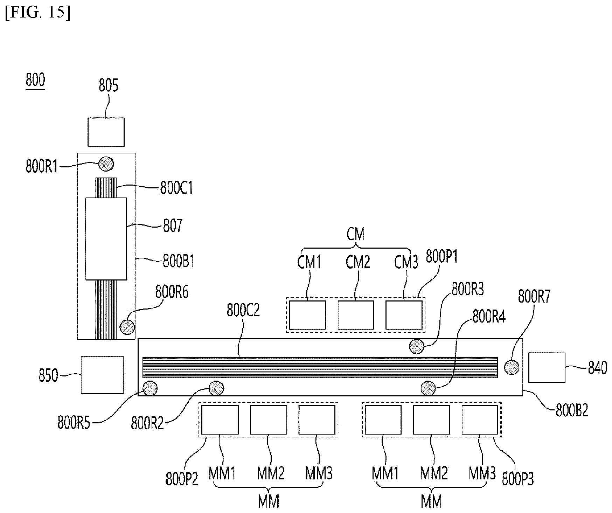

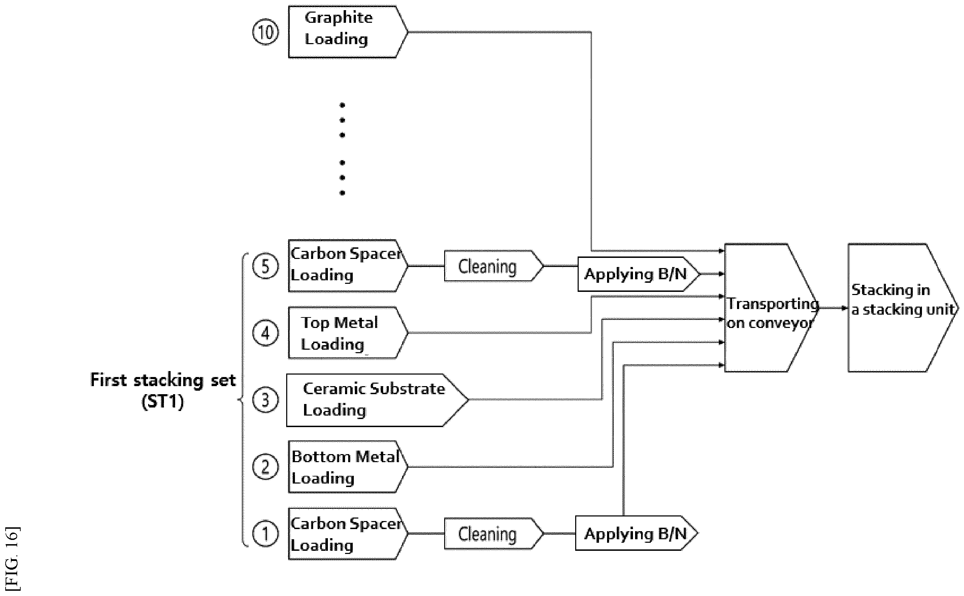

FIGS. 14 and 15 are schematic diagrams of an automatic alignment stacking device 800 of an insulating substrate and a metal plate in an embodiment, and FIG. 16 is a flowchart of a stacking process of an insulating substrate and a metal plate.

Internal technology relied on manual work for the insulating substrate and metal plate stacking process. Meanwhile, when the stacking process was carried out manually, it was difficult to consider matching the thickness of the insulating substrate and metal plate, and even controlling the placement of the metal plates on the upper and lower sides of the insulating substrate was not easy.

In particular, in the internal technology, the stacking set of the heat dissipation substrate includes an insulating substrate and a metal plate disposed on the top and bottom, and the alignment of the insulating substrate and the metal plate has been studied as a very difficult technical challenge in realizing a high degree of stacking with dozens to close to 100 sets of stacking sets.

In other words, if the alignment of the insulating substrate and metal plate is not even slightly correct, there is a problem of bonding defects occurring in the subsequent hot-pressing process which is carried out under tens of tons of pressure.

Accordingly, the inventors of this application invented an 'automatic alignment stacking system 800' that is capable of automatic stacking and automatic alignment of insulating substrates and metal plates.

Referring to FIG. 16 for a moment, the stacking process of the insulating substrate and the metal plate may include ① loading process of carbon spacer, ② loading process of lower metal plate, ③ loading process of insulating substrate, ④ loading process of upper metal plate, (5) loading process of carbon spacer, and ⑩ loading process of graphite.

First, the 'automatic alignment stacking system 800' of the insulating substrate and metal plate will be described with reference to FIGS. 14 and 15.

Referring to FIG. 14, the automatic alignment stacking system 800 in the embodiment may include a spacer port 805, a first substrate port 800P1, a second metal port 800P2, and a third metal port 800P3, a graphite port 840, and a stacking unit 850.

In addition, the automatic alignment stacking system 800 of the embodiment may include a first conveyor 800C1 and a particle applicator device 807 on the first shelf 800B1 and a second conveyor 800C2 on the second shelf 800B2.

Hereinafter, the characteristics of each apparatus will be described in detail with reference to FIG. 15.

The automatic alignment stacking system 800 according to the embodiment can implement automatic transfer or automatic stacking of each insulating substrate, metal plate, etc. using an automatic transfer device. For example, the automatic transfer device may include first to seventh transfer devices 800R1, 800R2, 800R3, 800R4, 800R5, 800R6, 800R7, which include a robot equipped with a transfer arm and a server motor, etc, but it is not limited to this.

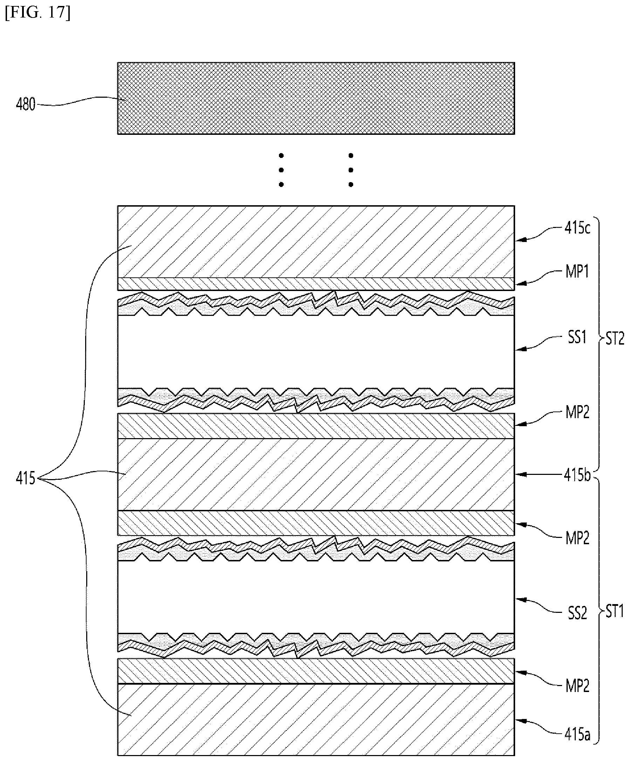

First, a predetermined spacer 415 (see FIG. 17) may be loaded into the spacer port 805. The spacer 415 may be a carbon spacer or a ceramic spacer, but is not limited thereto.

Additionally, the embodiment may include a particle application device 807 on the first conveyor 800C1. The operation of the particle application device 807 will be described later.

Next, the first substrate port 800P1 may include a substrate magazine CM in which sputtered insulating substrates are classified and loaded by thickness. For example, the first substrate port 800P1 may include first to third substrate magazines CM1, CM2, and CM3 in which sputtered insulating substrates are classified and loaded according to thickness.

Next, the second metal port 800P2 may include a metal magazine MM in which metal plates are classified and loaded by thickness. For example, the second metal port 800P2 may include first to third metal magazines MM1, MM2, and MM3 in which metal plates are classified and loaded according to thickness.

A lower metal plate disposed below the insulating substrate during a stacking process may be loaded in the second metal port 800P2.

Next, the third metal port 800P3 may also include a metal magazine MM in which metal plates are classified and loaded by thickness. For example, the third metal port 800P3 may include first to third metal magazines MM1, MM2, and MM3 in which metal plates are classified and loaded according to thickness.

An upper metal plate disposed on the upper side of the insulating substrate during a stacking process may be loaded into the third metal pot 800P3.

Next, a certain amount of graphite 480 (see FIG. 17) can be loaded into the graphite port 840. The graphite 480 can function as an anti-adhesion sheet.

Hereinafter, a stacking process using the automatic alignment stacking system 800 according to an embodiment will be described with reference to FIGS. 15 to 17.

First, the first spacer 415a may be loaded on the first conveyor 800C1 by the first transfer device 800R1 and then moved to the particle applicator device 807.

Before entering the particle application device 807, a cleaning process such as CDA may be performed on the first spacer 415a.

After the cleaning process, predetermined particles may be sprayed with air onto one surface of the first spacer 415a by the particle application device 807 and coated with a roller. Afterwards, it can be flipped and particles can be applied to the surface.

The particles may include boron nitride (B/N), etc., and are intended to facilitate separation of the heat dissipation substrate after the hot press bonding process.

The first spacer 415a moved by the first conveyor 800C1 may be stacked on the stacking unit 850 by the sixth transfer device 800R6.

According to the example, the quality of the heat dissipation substrate can be improved and the process time can be shortened by automating and uniformizing the particle application process.

Next, the metal plate loaded on the second metal port 800P2 can be unloaded onto the second conveyor 800C2 of the second shelf 800B2 by the second transfer device 800R2.

For example, the second metal plate MP2 loaded on the second metal magazine MM2 of the second metal port 800P2 may be moved to the second metal plate MP2 on the second shelf 800B2 by the second transfer device 800R2 and may be unloaded on conveyor 800C2.

Afterwards, the second metal plate MP2 moved by the second conveyor 800C2 may be stacked on the stacking unit 850 by the fifth transfer device 800R5. The second metal plate MP2 may be stacked on the first spacer 415a.

Next, the insulating substrate loaded on the first substrate port 800P1 can be unloaded onto the second conveyor 800C2 of the second shelf 800B2 by the third transfer device 800R3.

For example, the second insulating substrate SS2 loaded in the second substrate magazine CM2 of the second metal port 800P2 may be unloaded on the second conveyor 800C2 by the third transfer device 800R3.

Afterwards, the second insulating substrate SS2 moved by the second conveyor 800C2 may be stacked on the stacking unit 850 by the fifth transfer device 800R5. The second insulating substrate SS2 may be stacked on the second metal plate MP2.

Next, the metal plate loaded on the third metal port 800P3 can be unloaded onto the second conveyor 800C2 of the second shelf 800B2 by the fourth transfer device 800R4.

For example, the second metal plate MP2 loaded on the second metal magazine MM2 of the third metal port 800P3 may be unloaded on conveyor 800C2 of the second shelf 800B2 by the fourth transfer device 800R4.

Afterwards, the second metal plate MP2 moved by the second conveyor 800C2 may be stacked on the stacking unit 850 by the fifth transfer device 800R5. The second metal plate MP2 may be stacked on the second insulating substrate SS2.

Next, the second spacer 415b may be loaded onto the first conveyor 800C1 by the first transfer device 800R1 and then moved to the particle applicator device 807.

Before entering the particle application device 807, a cleaning process such as CDA may be performed.

After the cleaning process, predetermined particles may be air sprayed onto one surface of the second spacer 415b by the particle application device 807 and coated with a roller. Afterwards, the second spacer 415b can be flipped and particles can be applied to the surface.

The particles may include boron nitride (B/N), etc., and are intended to facilitate separation of the heat dissipation substrate after the hot press bonding process.

The second spacer 415b moved by the first conveyor 800C1 may be stacked on the stacking unit 850 by the sixth transfer device 800R6. The second spacer 415b may be stacked on the second metal plate MP2.

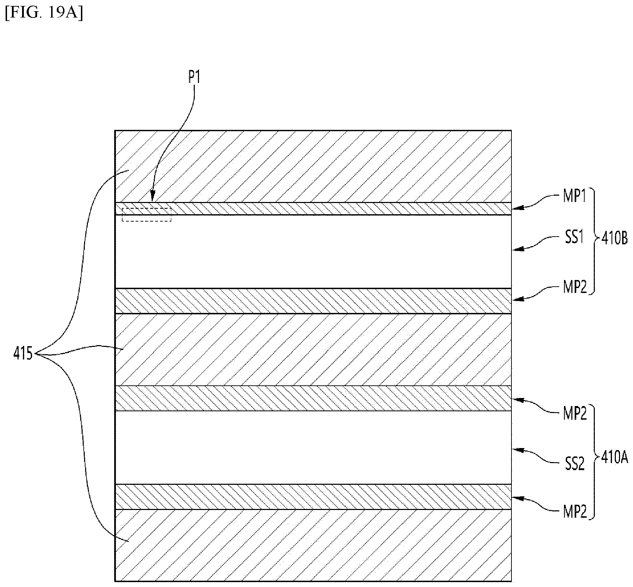

Through this, the first stacking set ST1, which will become the heat dissipation substrate 410A (see FIG. 19A) of the first embodiment, may be prepared (see FIG. 17).

Afterwards, the stacking process of the second stacking set ST2, which will become the heat dissipation substrate 410B (see FIG. 19A) of the second embodiment, may be performed (see FIG. 17). For example, referring to FIG. 17, a second metal plate MP2, a first insulating substrate SS1, a first metal plate MP1, and a third spacer 415c may be stacked sequentially on the second spacer 415b.

In the embodiment, the graphite 480 may be stacked after 10 stacking sets are performed, but the method is not limited thereto.

As described above, according to internal research, the problem that the distance between circuit patterns increases as the metal plate on the heat dissipation substrate becomes thicker has been studied. For example, when the thickness of the Cu plate was about 0.2 mm, the separation distance between circuit patterns was about 0.4 mm. However, when the thickness of the Cu plate is about 0.4mm, there is an issue in that the separation distance between circuit patterns is about 0.6mm.

In internal technology, the thickness of the metal plates bonded to the top and bottom of the heat dissipation substrate was managed within a certain thickness range, and when etching the metal plate, etching was performed to ensure an average separation distance.

Meanwhile, in order to implement high-performance power semiconductor devices, complex circuit patterns are required as multiple SiC power semiconductors are mounted on a heat dissipation substrate, and if the separation distance between circuit patterns is widened more than necessary, it is difficult to implement high-density power semiconductor modules.

Accordingly, the inventors of this application can control the thickness of the metal plate on one side of the heat dissipation substrate on which the circuit pattern is formed to be different from the thickness of the metal plate on the other side.

According to the embodiment, the thickness of insulating substrates and metal plates delivered in various thicknesses can be closely measured and managed, and each of these thickness information can be matched to the product specifications required by each customer through unique information UC by updating it perfectly.

For example, since a certain unique code UC is marked on the upper side of the insulating substrate, the marked upper side with the unique code UC can be managed as the upper side of the insulating substrate during the stacking process.

Accordingly, the unique code UC can function as an alignment function to distinguish between the upper and lower sides during the stacking process as well as the product history of each insulating substrate. There is a special technical effect in that the hot press process can be controlled by stacking metal plates with an optimal combination of thickness.

For example, referring to FIG. 17, the second stacking set ST2, which will become the heat dissipation substrate 410B of the second embodiment, may include a first metal plate MP1 of a first thickness T1 stacked on the first side of the first insulating substrate SS1 facing a predetermined power semiconductor device 100 and a second metal plate MP2 of a second thickness T2 stacked on the second side of the first insulating substrate SS1.

In the second embodiment, the first thickness T1 of the first metal plate MP1 may be less than or equal to the second thickness T2 of the second metal plate MP2. For example, in the second embodiment, the first thickness T1 of the first metal plate MP1 may be less than the second thickness T2 of the second metal plate MP2.

In an embodiment, the first thickness T1 of the first metal plate MP1 may be in the range of 50% to 100% of the second thickness T2 of the second metal plate MP2. Alternatively, the first thickness T1 of the first metal plate MP1 may be in the range of 60% to 90% of the second thickness T2 of the second metal plate MP2, but is not limited thereto.

According to the heat dissipation substrate 410B of the second embodiment, the first thickness T1 of the first metal plate MP1 bonded to the power semiconductor device 100 can be controlled to be thin, and accordingly, the first metal plate MP1 bonded to the power semiconductor device 100 can be controlled to be thin. There is a technical effect of providing a high-density power semiconductor module by ensuring a compact separation distance PD between the first circuit patterns CP1 of the plate MP1.

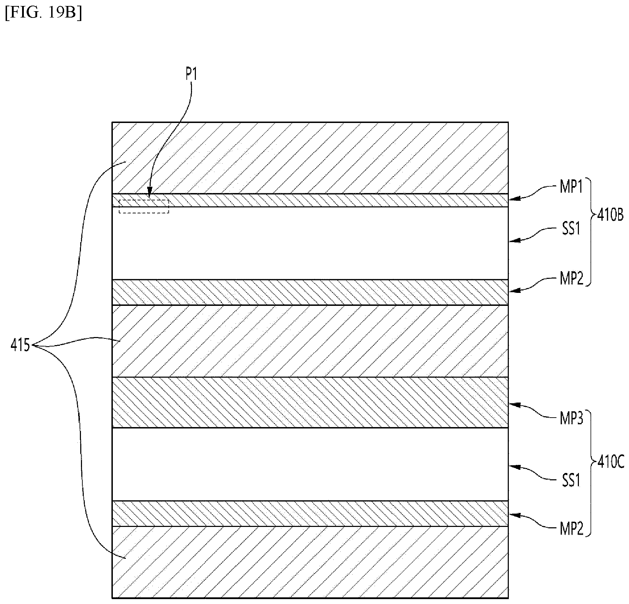

Next, Figure 19B is a manufacturing process diagram including the heat dissipation substrate 410C of the third embodiment.

The manufacturing process of the heat dissipation substrate 410C of the third embodiment may adopt the technical features of the heat dissipation substrate 410A of the first embodiment or the heat dissipation substrate 410B of the second embodiment described above, hereinafter the description will focus on the technical features referred to as the third embodiment.

As previously described, according to internal research, during transient liquid phase bonding (TLP), the IMC bonding layer is not properly formed as the metal plate material of the heat dissipation substrate is used up to form the IMC. So, problems with lowered bond strength or porosity were studied.

However, in power semiconductor modules operating at extremely high temperatures, a decrease in the adhesion between the power semiconductor device and the heat dissipation substrate or the presence of pores at the bonding interface may have a significant impact on the performance degradation and reliability of the power semiconductor module.

Accordingly, the inventors of this application can control the thickness of the metal plate on one side of the heat dissipation substrate on which the circuit pattern is formed to be different from the thickness of the metal plate on the other side.

For example, referring to FIG. 19B, the heat dissipation substrate 410C of the third embodiment may include a third metal plate MP3 of a third thickness T3 bonded on the first side of the first insulating substrate SS1 and a second metal plate MP2 of a second thickness T2 bonded on the second surface of the first insulating substrate SS1.

A power semiconductor device 100 may be bonded to the third metal plate MP3.

In the heat dissipation substrate 410C of the third embodiment, the third thickness T3 of the third metal plate MP3 may be greater than or equal to the second thickness T2 of the second metal plate MP2. For example, in the third embodiment, the third thickness T3 of the third metal plate MP3 may exceed the second thickness T2 of the second metal plate MP2.

In the third embodiment, the third thickness T3 of the third metal plate MP3 may be in the range of 100% to 200% of the second thickness T2 of the second metal plate MP2. Alternatively, the third thickness T3 of the third metal plate MP3 may be in the range of 120% to 150% of the second thickness T2 of the second metal plate MP2, but is not limited thereto.

According to the heat dissipation substrate 410C of the third embodiment, the third thickness T3 of the third metal plate MP3 facing the power semiconductor device 100 is bonded to the second thickness T3 can be controlled to be equal to or exceed the second thickness T2 of the second metal plate MP2 stacked on the opposite side of the insulating substrate.

According to the third embodiment, the third thickness T3 of the third metal plate MP3 bonded to the power semiconductor device 100 can be controlled to be thick, and accordingly, the third thickness of the circuit patterns can be also controlled to be equal to or greater than the second thickness T2 of the second metal plate MP2. Therefore, during transient liquid phase bonding of the power semiconductor device 100 and the third metal plate MP3, the issue of exhaustion of the metal plate material of the heat dissipation substrate during the IMC formation process can be prevented. So, there is a special technical effect in improving bonding strength and solving the problem of pores occurring at the bonding interface.

Referring again to FIG. 15, automatic stacking and automatic alignment of an insulating substrate and a metal plate can be implemented using the automatic alignment stacking system 800 according to the embodiment.

According to the 'automatic alignment stacking system 800' according to the embodiment, automatic stacking and hot press bonding processes of dozens to over 100 sets are possible.

In particular, according to the embodiment, the bottom of the stacking unit 850 may have a tilted structure, which has a special technical effect that enables precise automatic alignment of the edges of the sequentially stacked spacers, metal plates, and insulating substrates.

For example, according to the embodiment, there is a special technical effect that can innovatively increase vertical alignment accuracy by using gravity through tilting stacking.

As a result, precise automatic alignment can be possible as automatic stacking of tens to over 100 sets is performed, and alignment can be accurately maintained even during the hot press joining process exceeding tens of tons pressure. So, there is a special technical effect that makes it possible to implement no distortion of the stacking set, and to implement a high-quality heat dissipation substrate.

Also, according to the embodiment, a predetermined unique code UC is marked on one edge of the insulating substrate, so during the stacking process of the insulating substrate, the unique code UC may be arranged to match the bottom edge of the tilted structure of the stacking unit 850 to proceed with the stacking process.

Accordingly, the unique code UC has a special technical effect in that it can serve not only the product history of each insulating substrate but also the alignment function of the stacking position for the stacking unit 850 during the stacking process.

According to an embodiment, when the unique code is opened for inspection and history management process of a bonded heat dissipation substrate after the hot press process, the unique code can be opened as the hot press process progresses with the unique code placed at a certain position, so there is a special technical effect that allows the process to proceed quickly and accurately.

According to the embodiment, a stacking set stacked by an automatic alignment stacking system device may be fastened to a predetermined carrier clamp, and by inserting a predetermined guide transfer device into the stacking carrier, a precisely aligned stacking set can be put into a hot press with the alignment maintained.

### (Hot press process)

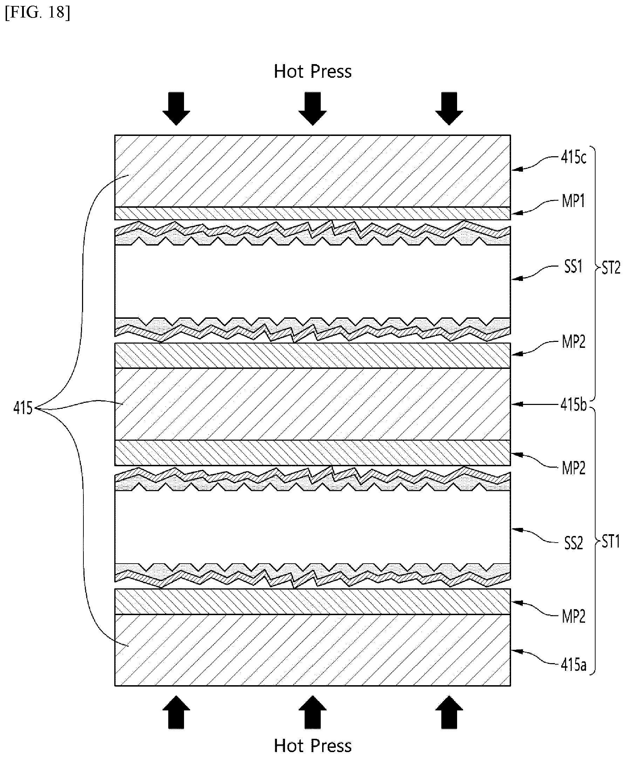

Next, the hot press bonding process of the embodiment will be described with reference to FIGS. 18 to 19B.

Referring to FIG. 18, the hot press process may be performed in a vacuum state on the stacking set inputted into a hot press device (not shown), so that first, second heat dissipation substrates 410A and 410B can be manufactured as shown in FIG. 19B.

For example, the first stacking set ST1 including the second metal plate MP2, the second insulating substrate SS2, and the second metal plate MP2 may be manufactured as the heat dissipation substrate 410A of the first embodiment.

Additionally, the second stacking set ST2 including the first metal plate MP1, the first insulating substrate SS1, and the second metal plate MP2 may be manufactured as the heat dissipation substrate 410B of the second embodiment.

Additionally, the third stacking set ST3 including the second metal plate MP2, the first insulating substrate SS1, and the third metal plate MP3 may be manufactured as the heat dissipation substrate 410C of the third embodiment.

The temperature of the hot press process may be about 900°C to 1,100°C. Preferably, the temperature of the hot press process may be about 950°C to 1,000°C, but is not limited thereto.

The vacuum degree of the hot press process may be 1.0×10⁻¹ torr or more, but is not limited thereto. Additionally, the pressure of the hot press process may be from about 10 MPa to about 100 MPa, but is not limited thereto.

### (Inspection and etching process of heat dissipation substrate)

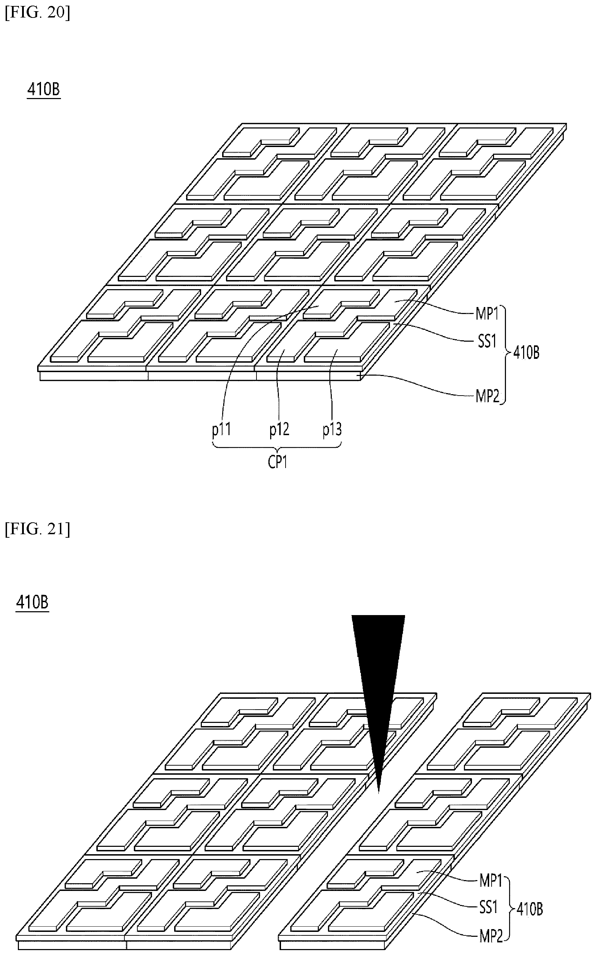

The inspection process and etching of the heat dissipation substrate will be described with reference to FIG. 20.

Referring to FIG. 20, a cleaning process, an inspection process, and an etching process may be performed on each heat dissipation substrate manufactured through the hot press bonding process.

The heat dissipation substrate 410B of the second embodiment shown in FIG. 20 may have a structure including the first metal plate MP1, the first insulating substrate SS 1, and the second metal plate MP2, but is not limited thereto.

For example, the cleaning process may be performed on the heat dissipation substrate 410B of the second embodiment manufactured through the hot press bonding process. For example, a brush cleaning, water washing, and a drying process may be performed on the heat dissipation substrate 410B of the second embodiment, but the process is not limited thereto.

Additionally, in the embodiment, an ultrasonic inspection of the bonding interface may be performed on the heat dissipation substrate manufactured by the hot press process.

For example, according to the embodiment, the first bonding interface of each heat dissipation substrate may be inspected for the interface thickness, presence of voids, and cracks using ultrasonic inspection equipment.

According to the embodiment, after the hot press bonding process, a portion of the metal plate in the dummy area of each heat dissipation substrate may be removed to open the unique code UC formed in the dummy area.

This has the special technical effect of being able to precisely update and manage inspection information on the interface thickness, presence of voids, and cracks on the bonding interface of individual heat dissipation substrates after the hot press process.

Continuing with reference to FIG. 20, the etching process to form a circuit pattern may be performed on the heat dissipation substrate determined to be a good product in the inspection process.

For example, a first circuit pattern CP1 may be formed through the etching process on the heat dissipation substrate 410B of the second embodiment on which a hot press process has been performed. For example, a first circuit pattern CP1 may be formed by partially removing the first metal plate MP1 of the heat dissipation substrate 410B of the second embodiment. The bonding metal layer 411 and the bonding layer 413 on the first insulating substrate SS1 may also be removed.

The embodiment has a special technical effect in that etching information (etchant, etching process conditions, etc.) for individual heat dissipation substrates can be precisely updated and managed after the hot press process.

Also, referring to FIG. 20, the heat dissipation substrate 410B of the second embodiment may include a first metal plate MP1 having a first thickness T1 on the first side of the first insulating substrate SS1 facing the predetermined power semiconductor device 100 and a second metal plate MP2 of a second thickness T2 stacked on the second surface of the first insulating substrate SS1.

In the second embodiment, the first thickness T1 of the first metal plate MP1 may be less than or equal to the second thickness T2 of the second metal plate MP2. For example, in the second embodiment, the first thickness T1 of the first metal plate MP1 may be less than the second thickness T2 of the second metal plate MP2.

On the first metal plate MP1, first circuit patterns CP1 including a first-first pattern p11, a first-second pattern p12, and a first-third pattern p13 can be formed by etching.

According to the heat dissipation substrate 410B of the second embodiment, the first thickness T1 of the first metal plate MP1 bonded to the power semiconductor device 100 can be controlled to be thin, and accordingly, there is a technical effect of providing a high-density power semiconductor module by securing a compact separation distance between the first circuit patterns CP1 of the plate MP1.

### (Inspection and cutting process)

Next, a laser scribing process, an inspection process, and a cutting process for the heat dissipation substrate will be described with reference to FIGS. 21 to 22.

Referring to FIG. 21, the etching inspection may be performed on the heat dissipation substrate for which the etching process has been completed.

For heat dissipation substrates that have a good etching test, the unique code UC may be marked on the metal plate. For example, when one heat dissipation substrate includes 9 snap areas, unique code UC may be marked on the metal plate on which a circuit pattern is not formed for each snap, for example, on each snap of the second metal plate MP2.

Unique code UC marking on each snap area of the second metal plate MP2 may be performed after the laser scribing.

Next, the laser scribing process and the breaking process may be performed.

In the embodiment, the inspection process may be performed after the laser scribing process and before the breaking process. The inspection process may include ultrasonic testing (SAT), which secondarily inspects voids or cracks at the junction interface using ultrasonic waves.

In addition, the inspection process after the laser scribing process may include a process of analyzing surface information such as surface roughness, surface pinhole inspection, protrusion inspection, and foreign matter inspection through an automatic appearance inspection process.

The embodiment has a special technical effect in that secondary bonding interface inspection information and automatic appearance inspection information for individual heat dissipation substrates can be precisely updated and managed after the etching process.

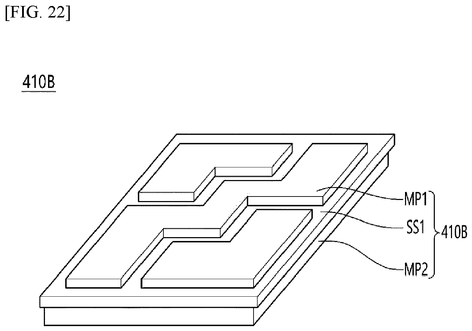

Thereafter, an individual heat dissipation substrate can be manufactured as shown in FIG. 22 through a cutting and separation process for the final good product. The first metal plate MP1 of the heat dissipation substrate 410B of the second embodiment shown in FIG. 22 may be delivered with the unique code UC marked.

Accordingly, according to the embodiment, unique information that can confirm information about the history of all processes from the initial warehousing stage of the product can be perfectly matched to the final product and delivered to the customer, and customers can also accurately understand and use the product quality and production history through the unique information, or make requests for after-sales service quickly and accurately when necessary.

Meanwhile, simply marking product information on the heat dissipation substrate of the final product cannot perfectly match and manage the film formation information, such as the thickness information of the insulating substrate that constitutes the product, the thickness information of the metal plate, and the bonding interface information.

According to the heat dissipation substrate 410B of the second embodiment, the first thickness T1 of the first metal plate MP1 bonded to the power semiconductor device 100 can be controlled to be thin, and accordingly, the first metal plate MP1 bonded to the power semiconductor device 100 can be controlled to be thin. There is a technical effect of providing a high-density power semiconductor module by ensuring a compact separation distance PD between the first circuit patterns CP1 of the plate MP1.

According to the third embodiment, the third thickness T3 of the third metal plate MP3 bonded to the power semiconductor device 100 can be controlled to be thick, and accordingly, the third thickness of the circuit patterns can be also controlled to be equal to or greater than the second thickness T2 of the second metal plate MP2. Therefore, during transient liquid phase bonding of the power semiconductor device 100 and the third metal plate MP3, the issue of exhaustion of the metal plate material of the heat dissipation substrate during the IMC formation process can be prevented. So, there is a special technical effect in improving bonding strength and solving the problem of pores occurring at the bonding interface.

### <Power converter including heat dissipation substrate>

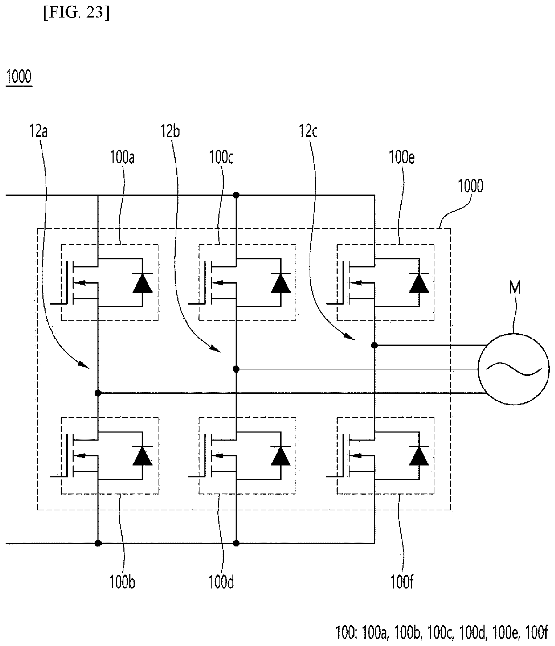

FIG. 23 is a circuit diagram of a power converter 1000 to which a power semiconductor module according to an embodiment is applied.

The power converter 1000 according to the embodiment may receive DC power from a battery or fuel cell and convert it into AC power, and supply AC power to a predetermined load. For example, the power converter 1000 according to the embodiment may include an inverter, receive DC power from a battery, convert it into three-phase AC power, and supply it to the motor M. The motor M can provide power to electric vehicles, fuel cell vehicles, etc.

The power converter 1000 according to the embodiment may include a power semiconductor device 100. The power semiconductor device 100 may be a MOSFET (Metal Oxide Semiconductor Field Effect Transistor), but is not limited thereto, and may include an IGBT (Insulated Gate Bipolar Transistor).

For example, the power converter 1000 may include a plurality of power semiconductor devices 100a, 100b, 100c, 100d, 100e, and 100f, and may include a plurality of diodes (not shown). Each of the plurality of diodes may be embedded in each of the power semiconductor devices 100a, 100b, 100c, 100d, 100e, and 100f in the form of an internal diode, but is not limited thereto, and may be disposed separately.

The embodiment may convert DC power to AC power through on-off control of a plurality of power semiconductor devices 100a to 100f. For example, the power converter 1000 according to the embodiment turns on the first power semiconductor device 100a and turns off the second power semiconductor device 100b in the first time period of one cycle to operate the motor M so the positive polarity power may be supplied. And negative polarity power may be supplied to the motor M by turning off the first power semiconductor device 100a and turning on the second power semiconductor device 100b in the second time period of one cycle.

In the embodiment, a group of power semiconductor devices arranged in series on the high-voltage line and low-voltage line on the input side may be called an arm. For example, the first and second power semiconductor devices 100a and 100b comprise the first arm 12a, and the third and fourth power semiconductor devices 100c and 100d comprise the second arm 12b, and the fifth and sixth power semiconductor devices 100e and 100f may comprise the third arm 12c.

A plurality of power semiconductor devices 100a to 100f shown in FIG. 23 may be packaged into one power semiconductor module, or the power semiconductor devices constituting each arm may be packaged into one power semiconductor module.

In the arm, the upper power semiconductor device and the lower power semiconductor device may be controlled not to be turned on at the same time. For example, in the first arm, the first power semiconductor device 100a and the second power semiconductor device 100b may not be turned on at the same time but may be alternately turned on and off.

The power semiconductor device 100 of the embodiment may be a silicon carbide (SiC) power semiconductor device, may operate in a high temperature and high voltage environment, and may have high switching speed and low switching loss.

According to the embodiment, there is technical effect in that accurately matches and updates management of all production and quality information and history for each 'individual heat dissipation substrate' in the manufacturing of heat dissipation substrates, including ceramic substrate thickness information, inspection information, copper plate thickness information, surface information, and bonding interface information after the bonding process.

In addition, according to the embodiment, even if the position or arrangement of the insulating substrate changes due to an operator's mistake during the manufacturing process, through the application of the embodiment, there is a technical effect of being able to completely update and manage the history of all processes, including the initial receipt of the individual insulating substrate, cleaning step, and hot pressing, by confirming the unique information of the individual insulating substrate.

In addition, according to the embodiment, unique information that can confirm information about the history of all processes from the initial warehousing stage of the product can be perfectly matched to the final product and delivered to the customer, and customers can also accurately understand and use the product quality and production history through the unique information, or make requests for after-sales service quickly and accurately when necessary.

In addition, according to the embodiment, there is a technical effect of minimizing thickness distribution by classifying individual insulating substrates and metal plates by thickness and matching them by thickness grade.

Accordingly, in the stacking process that proceed after the sputtering process, there is a technical effect that can optimize the thickness and quality of the heat dissipation substrate by reading the unique IDs of the first to third substrate magazines CM1, CM2, and CM3 and matching the insulating substrate and metal plate by thickness to perform the stacking and bonding process.

In addition, in the embodiment, the thickness of insulating substrates and copper plates delivered in various thicknesses are carefully measured and managed to perfectly manage this thickness information so that it can be matched to each product through unique information, and based on this unique information, thickness distribution is minimized.

Additionally, the embodiment has the technical effect of providing an automatic alignment stacking device capable of automatic stacking and automatic alignment of insulating substrates and metal plates.

In particular, according to the embodiment, the bottom of the stacking unit 850 may have a tilted structure, which has a special technical effect that enables precise automatic alignment of the edges of the sequentially stacked spacers, metal plates, and insulating substrates. For example, according to the embodiment, there is a special technical effect that can innovatively increase vertical alignment accuracy by using gravity through tilting stacking.

As a result, precise automatic alignment can be possible as automatic stacking of tens to over 100 sets is performed, and alignment can be accurately maintained even during the hot press joining process exceeding tens of tons pressure. So, there is a special technical effect that makes it possible to implement no distortion of the stacking set, and to implement a high-quality heat dissipation substrate.

Although the present invention has been described above with reference to the embodiments, those skilled in the art will easily understand that various modifications and changes can be made to the present invention without departing from the spirit and scope of the present invention as set forth in the claims below.

## Claims

1. A heat dissipation substrate for a power semiconductor module, comprising:
a first metal plate;
an insulating substrate bonded to the first metal plate; and
a second metal plate bonded on the insulating substrate,
wherein a first thickness of the first metal plate is different from a second thickness of the second metal plate.

2. The heat dissipation substrate according to claim 1, wherein the first thickness of the first metal plate is thinner than the second thickness of the second metal plate.

3. The heat dissipation substrate according to claim 1 or claim 2, wherein the first metal plate comprises a circuit pattern electrically connected to a power semiconductor device, and the second metal plate comprises a marked first unique code.

4. The heat dissipation substrate according to claim 3, wherein the first unique code comprises thickness information of the insulating substrate.

5. The heat dissipation substrate according to claim 3, wherein the first unique code comprises thickness information of at least one of the first metal plate and the second metal plate.

6. The heat dissipation substrate according to claim 3, wherein the insulating substrate comprises:
an effective area of the insulating substrate,
a dummy area of the insulating substrate disposed outside the effective area, and
a second unique code marked on the dummy area of the insulating substrate.

7. The heat dissipation substrate according to claim 6, wherein the first unique code of the second metal plate comprises a second unique code information of the insulating substrate.

8. The heat dissipation substrate according to claim 6, wherein the second unique code comprises a rectangular or square shape, and
wherein a vertex of the second unique code and a vertex of the effective area are arranged to face each other.

9. The heat dissipation substrate according to claim 1, wherein a first thickness of the first metal plate is thicker than a second thickness of the second metal plate.

10. The heat dissipation substrate according to claim 9, wherein the first metal plate comprises a circuit pattern electrically connected to a power semiconductor device, and the first metal plate comprises a unique code.

11. A power semiconductor module, comprising
a first heat dissipation substrate;
a power semiconductor device disposed on the first heat dissipation substrate;
a second heat dissipation substrate disposed on the power semiconductor device,
wherein the first heat dissipation substrate or the second heat dissipation substrate comprises the heat dissipation substrate according to claim 1.

12. The power semiconductor module according to claim 11, wherein the first heat dissipation substrate or the second heat dissipation substrate further comprising a bonding layer bonded between the circuit pattern of the first metal plate and the power semiconductor device by any one of sintering bonding, soldering bonding, or ultrasonic bonding.

13. The power semiconductor module according to claim 11, wherein a first thickness of the first metal plate is thinner than the second thickness of the second metal plate, wherein the first metal plate comprises a circuit pattern electrically connected to the power semiconductor device, and the second metal plate comprises a marked first unique code.

14. The power semiconductor module according to claim 13, wherein the first unique code comprises thickness information of at least one of the insulating substrate, the first metal plate and the second metal plate.

15. A power converter comprising the power semiconductor module of claim 13.
